# EUROPÄISCHE PATENTSCHRIFT

(11) **EP 0 948 813 B1**
(45) Veröffentlichungstag und Bekanntmachung des Hinweises auf die Patenterteilung: **10.07.2002**
(21) Anmeldenummer: 97913093.7
(22) Anmeldetag: 09.10.1997
(51) Int. Cl.: H01L 23/498

(54) **CHIPMODUL SOWIE VERFAHREN ZUR HERSTELLUNG EINES CHIPMODULS**
CHIP MODULE AND METHOD FOR PRODUCING THE SAME
MODULE A PUCES ET SON PROCEDE DE PRODUCTION

(30) Priorität: 14.10.1996 DE 19642358; 22.01.1997 DE 19702014
(43) Veröffentlichungstag der Anmeldung: 13.10.1999
(73) Patentinhaber: Pac Tech - Packaging Technologies GmbH, 14641 Nauen (DE)
(72) Erfinder: OPPERMANN, Hans-Hermann, D-10965 Berlin (DE); ZAKEL, Elke, D-14612 Falkensee (DE); AZDASHT, Ghassem, D-14052 Berlin (DE); KASULKE, Paul, D-10551 Berlin (DE)
(74) Vertreter: Böck, Bernhard, Dipl.-Ing.
(86) Internationale Anmeldenummer: DE9702320
(87) Internationale Veröffentlichungsnummer: WO9816953

(56) Entgegenhaltungen:
- EP-A- 0 582 052
- EP-A- 0 683 513
- EP-A- 0 702 404
- HEITMANN R: "THE ULTIMATE CONNECTIONS: BGA AND FLIP CHIP ATTACHMENT" ELECTRONIC PACKAGING AND PRODUCTION, Bd. 36, Nr. 5, 1.Mai 1996, Seiten 68-70, 72, 74 - 76, XP000589071

## Beschreibung

Die vorliegende Erfindung betrifft ein Chipmodul mit einem Chipträger und mindestens einem Chip, wobei der Chipträger als Folie ausgebildet ist mit einer Trägerschicht aus Kunststoff und einer Leiterbahnstruktur mit Leiterbahnen, und der Chipträger unter zwischenliegender Anordnung eines Füllstoffs mit dem Chip verbunden ist, wobei die Leiterbahnen auf ihrer Vorderseite mit Anschlußflächen des Chips verbunden sind und auf ihrer Rückseite Außenkontaktbereiche zur Ausbildung einer flächig verteilten Anschlußflächenanordnung zur Verbindung des Chipmoduls mit einem elektronischen Bauelement oder einem Substrat aufweisen. Des weiteren betrifft die Erfindung ein Verfahren zur Herstellung eines derartigen Chipmoduls.

Chipmodule der vorgenannten Art dienen beispielsweise dazu, um ausgehend von der sehr dichten, peripheren Anschlußflächenanordnung eines Chips über den mit einer Leiterbahnstruktur versehenen Chipträger eine flächig verteilte, weniger dichte Anschlußflächenanordnung zur Verbindung des Chips mit einer Platine oder dergleichen in konventioneller SMT(Surface-Mounted-Technology)-Technik zu ermöglichen. Ein ausreichend großer Abstand zwischen den einzelnen Anschlußflächen der Anschlußflächenanordnung erweist sich insbesondere deswegen als wichtig, weil die äußere Anschlußflächenanordnung in der Regel in einem Umschmelz(Reflow)-Verfahren mit der Platine oder dergleichen verbunden wird. Bei zu geringem Abstand zwischen den einzelnen Anschlußflächen kann es zu Kurzschlußverbindungen zwischen einzelnen Lotbumps der Anschlußflächenanordnung kommen.

Aufgrund zunehmender Anforderungen an die Miniaturisierung der Chipmodule wurden in der Vergangenheit, ausgehend von sogenannten "BGA"(Ball-Grid-Array)-Anschlußflächenverteilungen, Chipmodule entwickelt, die als "CSP"(Chip-Size-Package oder auch Chip-Scale-Package) bezeichnet werden. Im Gegensatz zu den vorgenannten BGAs, bei denen die flächige Umverteilung der Chipanschlußflächen auf einer im Vergleich zur Chipoberfläche wesentlich größeren Oberfläche mittels entsprechend großer Chipträger erfolgt, steht bei den mit CSP bezeichneten Chipmodulen für den Chipträger nur eine Fläche zur Verfügung, die im wesentlichen mit der Oberfläche des Chips übereinstimmt. Daher erweist es sich bei den CSPs als wesentlich, die zur Verfügung stehende Fläche bestmöglich auszunutzen.

Bei bekannten CSPs, wie sie beispielsweise aus der US-PS 5,367,763 oder aus "Proceedings of the 1993 International Symposium on Microelectronics (ISHM), Dallas, Texas, pp. 318-323" bekannt sind, wird der Randbereich der für den Chipträger zur Verfügung stehenden, mit der Oberfläche deckungsgleichen Fläche für die Anschlußverbindungen zwischen den Anschlußflächen des Chips und der Leiterbahnstruktur des Chipträgers verbraucht, so daß der Chipträger sich nur in einem um den Randbereich verminderten Innenflächenbereich erstreckt. Bei derart gebildeten Chipmodulen ist es daher notwendig, zur Erreichung einer vollständigen, auch die Anschlußflächen des Chips isolierend abdeckenden Gehäusung die Peripherie der Chipoberfläche in einem nachfolgenden Arbeitsschritt mit einer separaten Abdeckung, beispielsweise einem Verguß, zu versehen.

Aus der EP-A-0 702 404 ist ein Chipmodul bekannt, das einen Chipträger und einen Chip aufweist, wobei der Chipträger zur Verbindung von Leiterbahnen mit den Anschlußflächen des Chips eine zentrale Ausnehmung aufweist und sich somit peripher zur Chipoberfläche erstreckt.

Der vorliegenden Erfindung liegt daher die Aufgabe zugrunde, ein Chipmodul bzw. ein Verfahren zur Herstellung eines Chipmoduls vorzuschlagen, das eine bessere Ausnutzung der zur Anordnung des Chipträgers zur Verfügung stehenden Chipoberfläche bei gleichzeitig möglichst einfachem Aufbau des Chipmoduls ermöglicht.

Diese Aufgabe wird durch ein Chipmodul mit den Merkmalen des Anspruchs 1 bzw. ein Verfahren mit den Merkmalen des Anspruchs 8 gelöst.

Bei dem erfindungsgemäßen Chipmodul verlaufen die Leiterbahnen in einer Ebene auf der dem Chip zugewandten Chipkontaktseite der Trägerschicht. Hierdurch steht die Trägerschicht selbst zur voneinander isolierten Anordnung der umverteilten Anschlußflächen zur Verfügung, so daß die Außenkontaktbereiche zur Ausbildung der flächig verteilten Anschlußflächenanordnung durch Ausnehmungen in der Trägerschicht gebildet werden können, die sich gegen die Rückseite der Leiterbahn erstrecken. Darüber hinaus erstreckt sich die Trägerschicht bei dem erfindungsgemäßen Chipmodul über den Bereich der Anschlußflächen des Chips, so daß die gesamte Chipoberfläche durch die Trägerschicht des Chipträgers abgedeckt wird. Insgesamt resultiert hieraus ein sehr einfacher Aufbau und eine entsprechend einfache Herstellungsmöglichkeit des Chipmoduls.

In einer ersten Ausführungsform des erfindungsgemäßen Chipmoduls ist die Trägerschicht des Chipträgers im Überdeckungsbereich mit den Anschlußflächen des Chips geschlossen ausgebildet, so daß selbst dieser Überdeckungsbereich im peripheren Bereich der Chipträgeroberfläche zur Anordnung von äußeren Anschlußflächen auf der Chipträgeroberfläche zur Verfügung steht.

In einer weiteren Ausführungsform des erfindungsgemäßen Chipmoduls weist der Chipträger eine Trägerschicht auf, die in einem Überdeckungsbereich mit den Anschlußflächen des Chips Öffnungen hat, welche sich gegen die Rückseite der Leiterbahnen erstrecken und zur Aufnahme von die Leiterbahnen mit den zugeordneten Anschlußflächen elektrisch verbindendem Verbindungsmaterial dienen.

Diese Ausführungsform des Chipmoduls ermöglicht eine Herstellung, bei der sowohl die Ausnehmungen in der Trägerschicht, die zur Aufnahme von Verbindungsmaterial für die Kontaktierung des Chipmoduls mit einer Platine oder anderen Bauteilen vorgesehen sind, als auch die Öffnungen in der Trägerschicht in ein und demselben Verfahrensschritt mit Verbindungsmaterial befüllt werden können.

Die Ausführung des Chipmoduls gemäß Anspruch 4 ermöglicht eine gute Zugänglichkeit der Chipanschlußflächen für das Verbindungsmaterial, so daß eine hohe Kontaktsicherheit gewährleistet wird.

Für den Fall, daß eine Versiegelung bzw. mechanische Stabilisierung des Verbunds aus Chip und Chipträger allein aufgrund des zwischen dem Chip und dem Chipträger angeordneten Füllmaterials nicht ausreichend ist, kann zur Ergänzung längs der Peripherie des Chips verlaufend ein vorzugsweise aus dem Füllmaterial gebildeter Stützrahmen vorgesehen sein. Hierdurch wird in jedem Fall eine wirksame mechanische Stabilisierung des Chipmoduls erreicht, ohne daß hierzu die durch den Chip vorgegebenen Abmessungen des Chipmoduls wesentlich vergrößert werden müßten.

Alternativ zur vorgenannten Möglichkeit besteht jedoch auch die Möglichkeit, eine Versiegelung bzw mechanische Stabilisierung des Chipmoduls durch einen Verguß des Chips vorzusehen, der die Seitenflächen des Chips mit einem die Chipoberfläche überragenden Überstand des Chipträgers verbindet. Diese Art der Versiegelung bzw mechanischen Stabilisierung des Chipmoduls ist besonders dann vorteilhaft, wenn ein Chipmodul nach Art eines Chip-Size-Package geschaffen werden soll, bei der die Chipträgeroberfläche etwas größer als die Chipoberfläche ist, wodurch das Chipmodul einen Überstand des Chipträgers aufweist.

Für die Durchführung der Montage des Chipmoduls auf einem Substrat oder einer Platine in der bekannten SMT-Technik, bei der die auf der Chipträgeroberfläche angeordneten, beispielsweise mit Lotmaterial versehenen Außenkontaktbereiche mit entsprechend angeordneten Gegenkontakten auf dem Substrat oder der Platine verbunden werden, erweist es sich als vorteilhaft, wenn die Außenkontaktbereiche der Chipträgeroberfläche mit Lotmaterial versehen sind, dessen Schmelzpunkt niedriger ist als die zur thermischen Verbindung zwischen den Kontaktmetallisierungen des Chips und den Leiterbahnen des Chipträgers notwendige Temperatur. Hierdurch wird sichergestellt, daß es aufgrund der Temperaturbeaufschlagung des Chipmoduls zur Durchführung der Lötverbindung zwischen dem Chipträger und dem Substrat bzw. der Platine nicht zu einer Destabilisierung der Verbindungen zwischen den Kontaktmetallisierungen des Chips und den Leiterbahnen des Chipträgers kommen kann.

Als besonders vorteilhaft für die Herstellung von Chipmodulen erweist es sich, wenn die Chipmodule erfindungsgemäß in einem Modulverbund, der gebildet ist aus einem Chipträgerverbund mit einer Vielzahl zusammenhängend ausgebildeter Chiptrager und einem Chipverbund, insbesondere einem Wafer mit einer Vielzahl zusammenhängend ausgebildeter Chipeinheiten oder Dies, zusammengefaßt sind.

Bei Durchführung des erfindungsgemäßen Verfahrens nach Anspruch 9 zur Herstellung erfindungsgemäßer Chipmodule erfolgt zunächst ein Auftragen eines fließfähigen Füllmaterials auf die Chipoberfläche oder die Chipkontaktseite des Chipträgers. Dieses Füllmaterial dient einerseits zur abdichtenden Anordnung des Chipträgers auf dem Chip und andererseits zur mechanischen Stabilisierung des Chipträgers auf dem Chip. Das Füllmaterial kann auch Klebeeigenschaften zur Ausbildung eines flächigen Verbunds zwischen dem Chip und dem Chipträger aufweisen. Durch ein aneinander Andrücken des Chipträgers und des Chips erfolgt eine Verteilung des Füllmaterials im Spalt zwischen der Chipkontaktseite des Chipträgers und der Chipoberfläche. Aufgrund der Kontaktierung der Leiterbahnen mit den zugeordneten Kontaktmetallisierungen des Chips durch eine rückwärtige Energiebeaufschlagung der Leiterbahnen unter Zwischenlage der Trägerschicht bleibt auch bei der Kontaktierung die Oberfläche der Trägerschicht des Chipträgers geschlossen, so daß eine Verdrängung des Füllmaterials nur zur Seite hin erfolgen kann. Damit ist sichergestellt, daß das Füllmaterial die gesamte Chipoberfläche bedeckt und somit nach Herstellung der Verbindung zwischen dem Chipträger und dem Chip keine zusätzlichen Maßnahmen zur Ergänzung von Füllmaterial notwendig sind. Vielmehr erfolgt bei dem erfindungsgemäßen Verfahren die Kontaktierung des Chipträgers auf dem Chip und die Stabilisierung des Chipmoduls durch Verteilung eines Füllmaterials im Spalt zwischen dem Chipträger und dem Chip in einem einzigen Arbeitsgang.

Anspruch 10 betrifft ein alternatives erfindungsgemäßes Verfahren, bei dem anstatt des Auftragens von Füllmaterial ein bereits mit einer Kleberschicht versehener Chipträger verwendet wird.

Darüber hinaus bleibt infolge der vorgenannten rückwärtigen Energiebeaufschlagung der Leiterbahnen zur Kontaktierung des Chipträgers auf dem Chip und der dadurch erhaltenen Geschlossenheit der Trägerschicht des Chipträgers auch im Peripheriebereich des Chips die Möglichkeit, Außenkontaktbereiche zur Ausbildung der flächig verteilten Anschlußflächenanordnung auf der Chipträgeroberfläche vorzusehen.

Eine Alternative zu dem vorstehend erörterten erfindungsgemäßen Verfahren zur Herstellung einzelner Chipmodule besteht in dem erfindungsgemäßen Verfahren nach Anspruch 11, das die Herstellung einzelner erfindungsgemäßer Chipmodule durch Vereinzelung aus einem Modulverbund betrifft, in dem eine Vielzahl erfindungsgemäß ausgebildeter Chipmodule zusammenhängend ausgebildet sind. Hierzu erfolgt zunächst die Herstellung des Modulverbunds mit einem Chipträgerverbund und einem Chipverbund gemäß Anspruch 8 und anschließend die Herstellung einer Mehrzahl einzelner Chipmodule durch Vereinzelung von Einheiten aus zumindest einem Chip und einem damit kontaktierten Chipträger aus dem Modulverbund.

Dieses erfindungsgemäße Verfahren ermöglicht demnach die Herstellung von Chipmodulen auf Waferebene, wodurch mit relativ wenigen Handhabungs- oder Fertigungsschritten nicht nur die Herstellung eines einzelnen, sondern vielmehr die gleichzeitige Herstellung einer Vielzahl von Chipmodulen möglich wird.

Als besonders vorteilhaft erweist es sich, wenn zur Herstellung des Modulverbunds die nachfolgende Reihenfolge von Verfahrensschritten gemäß Anspruch 12 eingehalten wird:

Zunächst erfolgt die Bereitstellung eines Wafers, der mit erhöhten Kontaktmetallisierungen, die fachsprachlich auch als sogenannte "Bumps" bezeichnet werden, versehen ist, und die Bereitstellung eines Chipträgerverbunds, der eine Vielzahl von auf einer gemeinsamen Trägerschicht angeordneten Leiterbahnstrukturen mit Leiterbahnen aufweist, wobei die Leiterbahnstrukturen einer jeweils definierten Anzahl von im Wafer zusammenhängend ausgebildeten Chips zugeordnet sind. Anschließend erfolgt der Auftrag eines fließfähigen Füllmaterials auf die Kontaktfläche des Wafers oder die Chipkontaktseite des Chipträgerverbunds, wobei es sich bei diesem Füllmaterial beispielsweise um einen Epoxyd-Kleber handeln kann. Der Auftrag des Füllmaterial auf den Wafer kann als flächenförmig begrenzter Auftrag im Zentrum des Wafers erfolgen, gefolgt von einer Verteilung des Füllmaterials auf der Waferoberfläche durch eine Rotation des Wafers um seine Mittelpunktsachse. Vor der flächigen Verbindung des Chipträgerverbunds mit dem Wafer, die beispielsweise durch einen Laminiervorgang durchgeführt werden kann, erfolgt eine Relativpositionierung des Wafers und des Chipträgerverbunds, derart, daß sich eine Überdeckungslage zwischen den Kontaktmetallisierungen des Wafers und Kontaktbereichen der zugeordneten Leiterbahnen der Leiterbahnstrukturen einstellt. Schließlich erfolgt die flächige Verbindung zwischen dem Wafer und dem Chipträgerverbund, beispielsweise durch den vorstehend erwähnten Laminiervorgang, wobei der endgültigen Verbindung eine Vorfixierung in ausgewählten Punkten vorausgehen kann. Nach Herstellung der flächigen Verbindung oder gleichzeitig mit dieser erfolgt die Kontaktierung der Kontaktmetallisierungen des Wafers mit den zugeordneten Leiterbahnen des Chipträgerverbunds.

Bei einer zum vorstehend erläuterten Verfahren gemäß Anspruch 12 alternativen Vorgehensweise gemäß Anspruch 13 wird anstatt des Auftragens von Füllmaterial ein bereits mit einer Kleberschicht versehener Chipträgerverbund verwendet.

Wie bereits vorstehend im Zusammenhang mit dem erfindungsgemäßen Verfahren zur Herstellung eines einzelnen Chipmoduls erwähnt wurde, kann auch bei der Herstellung des gesamten Modulverbunds die Kontaktierung der Kontaktmetallisierungen des Wafers mit den Leiterbahnen des Chipträgerverbunds durch die Trägerschicht des Chipträgerverbunds hindurch erfolgen, also beispielsweise durch eine rückwärtige Kontaktierung ohne Zerstörung der Trägerschicht im Bereich der Kontaktstellen.

Als Hilfsmittel zur Relativpositionierung kann der Wafer mit mindestens zwei Positionierungsstiften versehen sein, die in korrespondierend ausgebildete Positionierungsöffnungen in der Trägerschicht des Chipträgerverbunds eingreifen. Derartige Positionierungsstifte können als "Dummy bumps" ausgebildet sein, die, ohne an der elektrischen Verbindung zwischen dem Wafer und dem Chipträgerverbund beteiligt zu sein, lediglich zur Erzielung und mechanischen Stabilisierung der Relativpositionierung in Eingriff mit der Trägerschicht des Chipträgerverbunds gelangen. Um nicht nur eine Starrkörperorientierung zwischen dem Wafer und dem Chipträgerverbund zu definieren, kann es sich als zweckmäßig erweisen, mehr als zwei Positionierungsstifte und eine entsprechende Anzahl von Positionierungsöffnungen vorzusehen, so daß Dehnungsbegrenzungen für beispielsweise thermisch bedingte Dehnungen in der Trägerschicht geschaffen werden.

Eine Alternative bezüglich einer vorteilhaften Vorgehensweise zur Herstellung eines Modulverbunds ist durch die folgenden Verfahrensschritte definiert:

Zunächst erfoigt wieder die Bereitstellung eines Wafers und eines Chipträgerverbunds mit einer Vielzahl von auf einer gemeinsamen Trägerschicht angeordneten Leiterbahnstrukturen mit Leiterbahnen, wobei bei dieser Verfahrensvariante ein Chipträgerverbund mit einer Trägerschicht verwendet wird, die Öffnungen aufweist, welche die Rückseite des Chipkontaktbereichs der Leiterbahnen und gegebenenfalls daran angrenzende Umgebungsbereiche freigeben. Anschließend erfolgt der Auftrag eines fließfähigen Füllmaterials, das, wie bei der vorstehend geschilderten Verfahrensvariante als ein Epoxyd-Kleber ausgebildet sein kann, auf die Kontaktoberfläche des Wafers oder die Chipkontaktseite des Chipträgerverbunds, derart, daß die Anschlußflächen des Wafers oder hierauf aufgebrachte Kontaktmetallisierungen bzw. die Öffnungen der Trägerschicht freibleiben. Hierauf erfolgt die Relativpositionierung des Wafers und des Chipträgerverbunds, derart, daß sich eine Überdeckungslage zwischen den Anschlußflächen des Wafers bzw. darauf aufgebauten Kontaktmetallisierungen und den Öffnungen in der Trägerschicht des Chipträgerverbunds einstellt. Anschließend erfolgt eine flächige Verbindung zwischen dem Wafer und dem Chipträgerverbund und eine Kontaktierung der Anschlußflächen des Wafers bzw. der darauf angeordneten Kontaktmetallisierungen mit den Chipkontaktbereichen der zugeordneten Leiterbahnen durch Einbringung von Verbindungsmaterial in die Öffnungen der Trägerschicht des Chipträgerverbunds.

Die vorstehend erörterte Verfahrensvariante ermöglicht die Herstellung von eingangs erörterten erfindungsgemäßen Chipmodulen, bei denen sowohl die Verbindungsmaterialdepots in den Ausnehmungen der Trägerschicht, die zur Kontaktierung des Chipmoduls mit anderen Bauteilen dienen, als auch das Verbindungsmaterial in den Öffnungen in der Trägerschicht zur Ermöglichung einer Kontaktierung zwischen den Leiterbahnen der Leiterbahnstruktur und den Chipanschlußflächen in einem Arbeitsgang eingebracht werden können.

Eine weitere Alternative ist durch ein Verfahren gemäß Anspruch 17 gegeben.

Die Kontaktierung kann durch Abscheidung von Verbindungsmaterial in den Öffnungen der Trägerschicht erfolgen, wobei sich in Versuchen besonders eine stromlose, also autokatalytische Abscheidung von Verbindungsmaterial durch Einbringung des Modulverbunds in ein entsprechendes Materialbad als vorteilhaft erwiesen hat. Bei diesem Materialbad kann es sich beispielsweise um ein Nickel-, Kupfer oder Palladiumbad handeln.

Die Kontaktierung kann auch durch Einbringung von Lotmaterial oder leitfähigem Kleber in die Öffnungen der Trägerschicht erfolgen, wobei hier alle bekannten Techniken zur Einbringung von Lotmaterial, also beispielsweise eine Schablonenbelotung oder auch eine Einbringung von stückigem Lotmaterial, eingesetzt werden können.

Gleichzeitig mit der Einbringung des Verbindungsmaterials in die Kontaktöffnungen der Trägerschicht kann eine Einbringung des Verbindungsmaterials in die Ausnehmungen der Trägerschicht erfolgen.

Unabhängig von der Art und Weise der Herstellung des Modulverbunds erweist es sich als vorteilhaft, wenn der Wafer auf seiner Rückseite mit einer Deckschicht versehen ist, die als Oberflächenschutz und auch zur Erzielung einer mechanischen Stützwirkung eingesetzt werden kann. Zusammen mit der Trägerschicht des Chipträgerverbunds ergibt sich somit nach Vereinzelung der Chipmodule aus dem Modulverbund ein gekapseltes Chipmodul.

Zur Erzeugung dieser Deckschicht hat sich ein Auftrag von Epoxyd-Material auf die Rückseite des Wafers als geeignet erwiesen. Eine weitere Möglichkeit besteht darin, zur Ausbildung der Deckschicht eine Folie auf die Rückseite des Wafers aufzubringen. Die Folie kann mit einer Beschriftung, beispielsweise zur Kennzeichnung einzelner Chips des Wafers, versehen sein.

Unabhängig von der Art und Weise der Herstellung des Modulverbunds erfolgt nach dessen Fertigstellung eine Vereinzelung von Chipmodulen aus dem Modulverbund durch Trennung aneinander angrenzender Chipmodule längs definierter Trennlinien. In diesem Zusammenhang erweist es sich als besonders vorteilhaft, wenn hierzu das ohnehin zur Vereinzelung von Chips aus einem Waferverbund eingesetzte Sägeverfahren durchgeführt wird.

Vor der Vereinzelung der Chipmodule aus dem Modulverbund kann eine hinsichtlich des Aufwands und der damit verbundenen Kosten besonders günstige elektrische Überprüfung der noch im Waferverbund angeordneten Chips über die Leiterbahnstrukturen des Chipträgerverbunds erfolgen.

Eine besonders gleichmäßige Form des Andrückens zur Herstellung der Verbindung zwischen dem Chipträger bzw. dem Chipträgerverbund und dem Chip bzw. dem Wafer wird erreicht, wenn das aneinander Andrücken der Chipträger bzw. des Chipträgerverbunds und der Chipoberfläche bzw. der Waferoberfläche mittels Vakuum erfolgt. Bei genügend steif ausgebildeter Folie oder auch durch Aufbringen einer Zugspannung in Folienlängsrichtung gegen Durchbiegung stabilisierter Folie kann es auch ausreichend sein, das Andrücken des Chipträgers allein durch die zur Energiebeaufschlagung des Chipträgers bzw. des Chipträgerverbunds verwendete Verbindungseinrichtung auszuführen. In diesem Fall dient der zur Verbindung der Leiterbahnen mit den Chipanschlußflächen erforderliche Anpressdruck gleichzeitig zum Andrücken des Chipträgers bzw. des Chipträgerverbunds gegen die Chipoberfläche bzw. die Waferoberfläche.

Zur Erzeugung von Lotbumps auf dem Chipträger bzw. dem Chipträgerverbund. die zur Verbindung des Chipmoduls mit einem Substrat, einer Platine oder dergleichen dienen, können die Außenkontaktbereiche des Chipträgers bzw. des Chipträgerverbunds in einem Schablonenauftragsverfahren mit Lotmaterial versehen werden, wobei die Trägerschicht selbst in einem nachfolgenden Umschmelzverfahren als Lötstopmaske dient. Hierdurch wird die Erzeugung der Lotbumps auf besonders einfache Art und Weise möglich.

Eine weitere Möglichkeit besteht darin, die Außenkontaktbereiche in einem Bestückungsverfahren mit Lotmaterialformstücken zu versehen, wobei in diesem Fall die durch die Ausnehmungen in der Trägerschicht gebildeten Außenkontaktbereiche als positionierende Aufnahmen für das Lotmaterial dienen.

Zur Verbindung zwischen den Kontaktmetallisierungen des Chips bzw. des Wafers und den Leiterbahnen des Chipträgers bzw. des Chipträgerverbunds können unterschiedliche Verfahren eingesetzt werden, deren gemeinsames Merkmal darin besteht, daß bei einer rückwärtigen Energiebeaufschlagung der Leiterbahnen unter Zwischenlage der Trägerschicht die Trägerschicht im wesentlichen unversehrt und geschlossen bleibt. Als besonders geeignete Verfahren erscheinen in diesem Zusammenhang Lötverfahren und Thermokompressionsverfahren, die mittels einer rückwärtigen Energiebeaufschlagung der Leiterbahnen mit Laserstrahlung durchgeführt werden, wobei die Laserstrahlung durch eine rückwärtig unter Druck an der Trägerschicht anliegende Lichtleitfaser eingeleitet wird. Eine weitere Möglichkeit besteht darin, ein Ultraschallverfahren einzusetzen, bei dem ein Ultraschallstempel rückwärtig auf die Trägerschicht aufgesetzt wird und durch die im Bereich der Verbindungsstelle komprimierte Trägerschicht Ultraschallschwingungen in die Verbindungsstelle zwischen der betreffenden Leiterbahn und der Chipanschlußfläche einbringt.

Nachfolgend wird ein Ausführungsbeispiel des erfindungsgemäßen Chipmoduls sowie ein mögliches Verfahren zur Herstellung eines derartigen Chipmoduls unter Bezugnahme auf die Zeichnungen näher erläutert. Es zeigen:
- **Fig. 1**: ein Ausführungsbeispiel eines Chipmoduls mit einem auf einem Chip kontaktierten Chipträger;
- **Fig. 2** bis **6**: den Aufbau eines Chipträgers;
- **Fig. 7**: den Chipträger und den Chip unmittelbar vor Herstellung des Chipmoduls;
- **Fig. 8**: den Chipträger und den Chip während der Herstellung der Verbindung zwischen dem Chipträger und dem Chip;
- **Fig. 9**: die Herstellung eines längs der Peripherie des Chips verlaufenden Dicht- bzw. Stützrahmens;
- **Fig. 10**: einen den Chip einschließenden Verguß;
- **Fig. 11**: die nachträgliche Applikation von Lotmaterial auf dem Chipträger;
- **Fig. 12** bis **14**: mehrere Beispiele für flächig verteilte Anschlußflächenanordnungen auf dem Chipträger verschiedener Chipmodule;
- **Fig. 15**: einen Modulverbund aus einem Wafer und einem darauf angeordneten Chipträgerverbund in Draufsicht;
- **Fig. 16**: eine vergrößerte Einzeldarstellung eines Chipträgers aus dem in **Fig. 15** dargestellten Chipträgerverbund;
- **Fig. 17**: eine Einzeldarstellung eines Verbindungsaufbaus zwischen einer Außenanschlußfläche eines Chipträgers und einer Chipanschlußfläche eines Chips in Draufsicht;
- **Fig. 18**: den in **Fig. 17** dargestellten Verbindungsaufbau in einer Seitenansicht vor der Applikation von Verbindungsmaterial;
- **Fig. 19**: eine in der Ansicht **Fig. 18** entsprechende Darstellung des Verbindungsaufbaus nach der Applikation von Verbindungsmaterial;
- **Fig. 20**: eine Schnittansicht der Verbindung zwischen einer Leiterbahn des Chipträgers und der Chipanschlußfläche gemäß dem Schnittlinienverlauf XX-XX in **Fig. 19.**

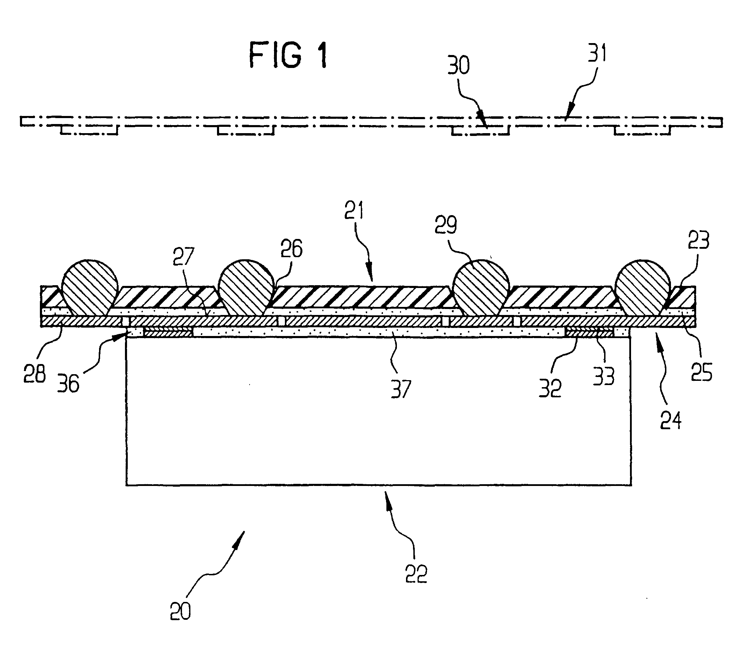

**Fig. 1** zeigt ein Chipmodul 20 mit einem Chipträger 21, der auf einem Chip 22 kontaktiert ist. Das in **Fig. 1** dargestellte Chipmodul 20 wird auch als Chip-Size-Package (CSP) bezeichnet, da die wesentlichen Abmessungen des Chipmoduls 20 durch den Chip 22 bestimmt sind. Als Definitionsgröße für ein CSP gilt in der Fachwelt allgemein ein Verhältnis von 0,8 bis 1,2 zwischen der Chipoberfläche und der Oberfläche des Chipträgers.

Bei dem in **Fig. 1** dargestellten Chipmodul 20 wird ein Chipträger 21 aus einer dreilagigen Folie verwendet mit einer Trägerschicht 23 aus Polyimid und einer als Leiterbahnstruktur 24 ausgebildeten Kontaktschicht aus Kupfer, die hier über eine Kleberschicht 25 mit der Trägerschicht 23 verbunden ist. Die Trägerschicht 23 ist mit Ausnehmungen 26 versehen, die sich von der Oberfläche der Trägerschicht 23 bis zu einer Rückseite 27 von die Leiterbahnstruktur 24 bildenden einzelnen Leiterbahnen 28 erstreckt. Diese Ausnehmungen 26 bilden Außenkontaktbereiche, die mit Lotmaterialdepots 29 zur Kontaktierung mit Anschlußflächen 30 eines in **Fig. 1** mit strichpunktiertem Linienverlauf angedeutetem Substrats 31 dienen.

**Fig. 1** zeigt beispielhaft zwei von einer Vielzahl peripher auf der Chipoberfläche angeordneten Chipanschlußflächen 32, die mit Kontaktmetallisierungen 33 versehen sind. Die Kontaktmetallisierungen sind mit jeweils zugeordneten Leiterbahnen 28 kontaktiert, so daß durch die Leiterbahnen 28 eine "Umverdrahtung" der peripher auf der Chipoberfläche angeordneten Chipanschlußflächen 32 in eine flächig verteilte, hinsichtlich des Abstandes zwischen den einzelnen Anschlußflächen aufgeweitete Anschlußflächenanordnung 34 auf der Oberfläche des Chipträgers 21 erfolgt. Zur abdichtenden Verbindung des Chipträgers 21 mit dem Chip 22 und zur mechanischen Stabilisierung des als flexible Folie ausgebildeten Chipträgers 21 ist in einem zwischen einer Chipkontaktseite 35 und der Chipoberfläche ausgebildeten Spalt 36 ein Füllmaterial 37 mit Haft- oder Klebewirkung vorgesehen, das fachsprachlich auch als "Underfiller" bezeichnet wird.

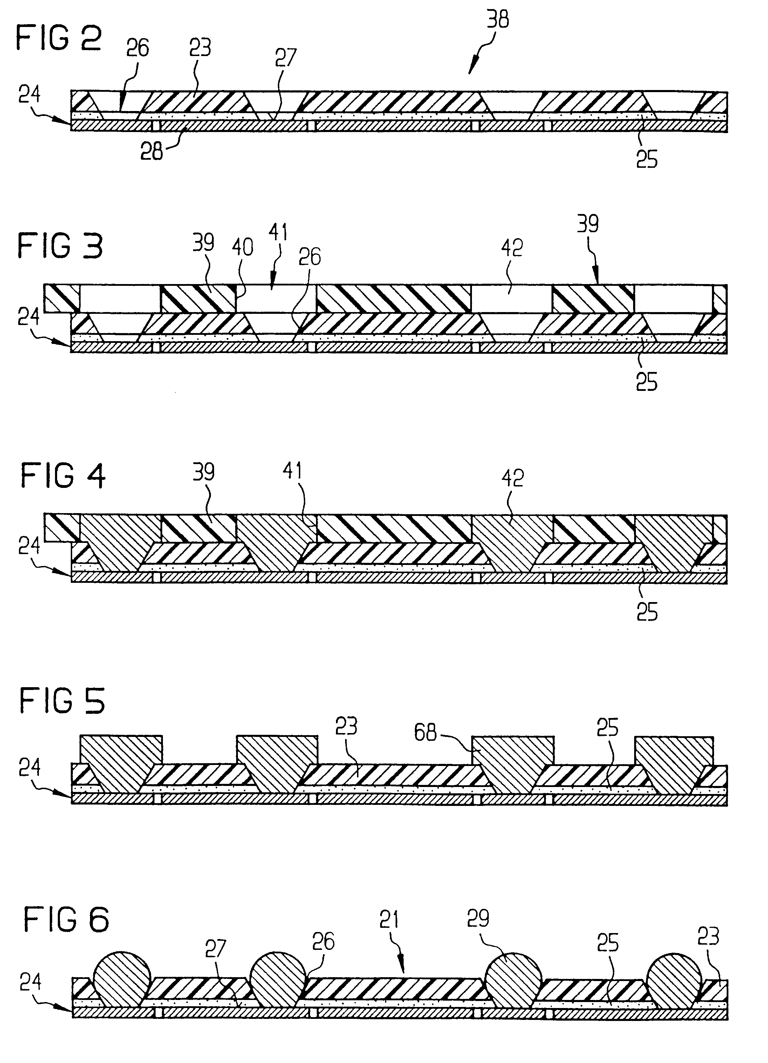

In den **Fig. 2** bis **6** ist in chronologischer Abfolge die Herstellung des in **Fig. 1** zur Erzeugung der Chipträger-Anordnung 20 verwendeten Chipträgers 21 erläutert. Wie **Fig. 2** zeigt, ist Basis bei der Herstellung des Chipträgers 21 eine dreilagige Folie 38 mit einer die Trägerschicht 23 mit der Leiterbahnstruktur 24 verbindenden Kleberschicht 25. In einer vereinfachten Ausführung ist es jedoch auch möglich, eine mit dem Chipträger 21 vergleichbare Ausführung eines Chipträgers, ausgehend von einer Folie, zu schaffen, bei der die Leiterbahnstruktur unmittelbar auf der Trägerschicht, also ohne zwischenliegende Anordnung einer Kleberschicht, angeordnet ist.

Die Folie 38, die als Endlosfolie ausgebildet sein kann, weist in jedem Fall die in der Trägerschicht 23 vorgesehenen, bis zur Rückseite 27 der Leiterbahnen 28 reichenden Ausnehmungen 26 auf, wobei die Ausnehmungen beispielsweise durch geeignete Ätzverfahren oder auch durch Laserablation erzeugt werden können.

Für den Fall, daß in den Ausnehmungen 26 mittels eines Schablonenauftragsverfahrens Lotmaterial 42 zur Erzeugung der Lotmaterialdepots 29 (**Fig. 1** und **6**) eingebracht werden soll, kann, wie in **Fig. 3** dargestellt, eine Schablone 39 auf die Trägerschicht 23 aufgelegt werden, und zwar so, daß in der Schablone 39 vorgesehene Schablonenöffnungen 40 dekkungsgleich mit den Ausnehmungen 26 in der Trägerschicht 23 zu liegen kommen.

In die aus den übereinanderliegend angeordneten Ausnehmungen 26 und Schablonenöffnungen 40 gebildeten Lotmaterialaufnahmen 41 wird nach flächigem Auftrag des Lotmaterials 42 auf die Oberfläche der Schablone 39 durch einen hier nicht näher dargestellten Rakel oder dergleichen eine Befüllung der Lotmaterialaufnahmen 41 mit Lotmaterial 42 in der in **Fig. 4** dargestellten Art und Weise erzielt.

Wie in **Fig. 5** dargestellt, verbleiben nach Abnahme der Schablone 39 von der Trägerschicht 23 beispielsweise aus pastösem Lotmaterial gebildete Lotmaterialmengen 68 in den Ausnehmungen 26. Durch ein nachfolgendes Umschmelzverfahren werden dann die in **Fig. 6** dargestellten meniskusartig geformten Lotmaterialdepots 29 erzeugt, wobei die Trägerschicht 23 während des Umschmelzens als Lötstopmaske dient.

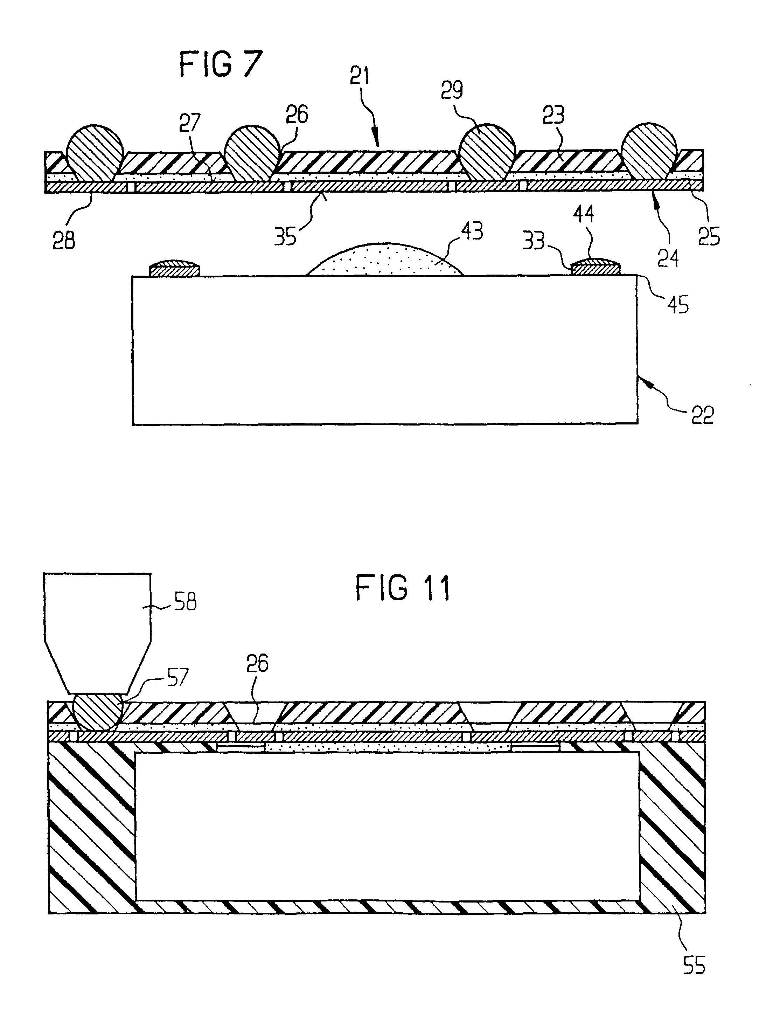

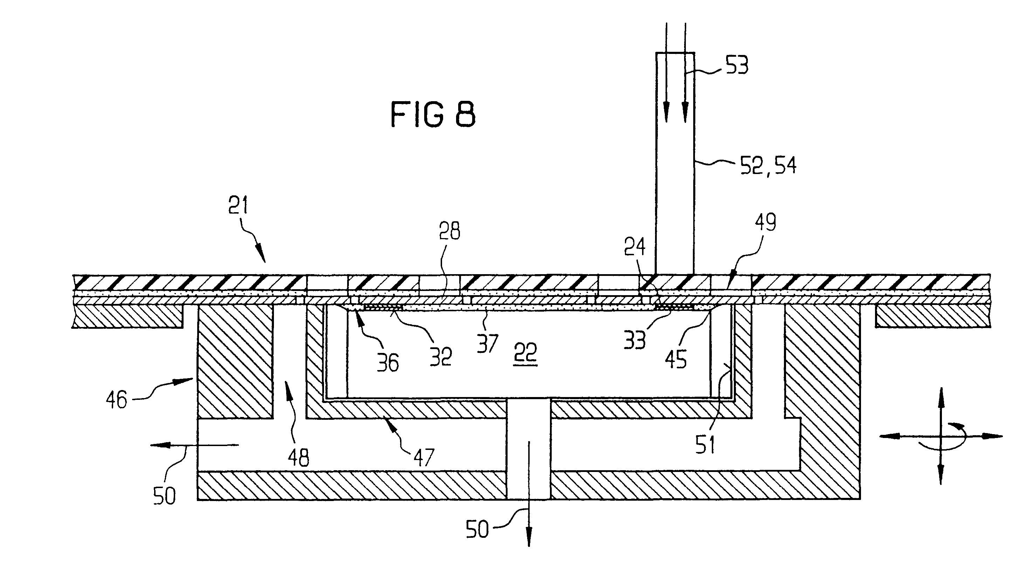

**Fig. 7** zeigt, wie ausgehend von dem entsprechend den Erläuterungen zu den **Fig. 2** bis **6** erzeugten Chipträger 21 das in **Fig. 1** dargestellte Chipmodul 20 gebildet wird. Hierzu erfolgt ein Auftrag einer definierten Füllmaterialmenge 43 auf die Chipoberfläche und eine dem gewählten Verfahren zur Verbindung der Kontaktmetallisierungen 33 des Chips mit den Leiterbahnen 28 des Chipträgers 21 entsprechende Präparierung der im Ausgangszustand aus Aluminium bestehenden Chipanschlußflächen 32. Im vorliegenden Fall sind die Chipanschlußflächen 32 mit als Nickelbumps ausgebildeten Kontaktmetallisierungen 33 mit einem Lotüberzug 44 aus einer Gold/Zinn-Legierung versehen, um die Kontaktierung der Leiterbahnen 28 des Chipträgers 21 mit den Kontaktmetallisierungen 33 des Chips 22 in einem nachfolgend unter Bezugnahme auf **Fig. 8** noch näher erläuterten Lötverfahren durchführen zu können.

Dabei kann der Gold/Zinn-Lotüberzug 44 durch einfaches Eintauchen der Kontaktmetallisierungen 33 in eine entsprechend flüssig ausgebildete Legierung aufgebracht werden.

Zur Herstellung des Chipmoduls 20 (**Fig. 1**), also des festen mechanischen Verbunds zwischen dem Chipträger 21 und dem Chip 22, wird nun der Chipträger 21 gegen die Oberfläche des Chips 22 gedrückt, so daß die auf die Chipoberfläche aufgebrachte Füllmaterialmenge 43 bei Ausbildung des Spaltes 36 zwischen der Chipkontaktseite 35 des Chipträgers 21 und der Chipoberfläche nach außen zur Peripherie des Chips 22 verdrängt wird und sich gleichmäßig auf der Chipoberfläche bis hin zu Außenrändern 45 des Chips 22 verteilt.

**Fig. 8** zeigt, daß dieses Andrücken des Chipträgers 21, der sich in der Darstellung gemäß **Fig. 8** noch im endlosen Folienverbund befindet, mittels einer Vakuumeinrichtung 46 ausgeführt werden kann, bei der der Chip 22 in einer Chipaufnahme 47 fixiert ist und der Chipträger 21 über einen die Chipaufnahme 47 umgebenden Ringkanal 48 durch Vakuumwirkung (Pfeil 50) gegen die Chipoberfläche gesogen wird. Dabei ist in **Fig. 8** deutlich zu erkennen, daß aufgrund des Kapillareffekts im Spalt 36 zwischen dem Chipträger 21 und dem Chip 22 eine Verteilung des Füllmaterials 37 über die Außenränder 45 des Chips 22 hinaus erfolgt, so daß sich im Bereich eines möglichen Überstands 49 des Chipträgers 21 über die Oberfläche des Chips 22 eine zusätzlich abstützende Wirkung ergibt.

Wie ebenfalls in **Fig. 8** dargestellt, kann zur Fixierung des Chips 22 in der Chipaufnahme 47 ebenfalls, wie durch den Pfeil 50 angedeutet, Vakuumwirkung eingesetzt werden. Um zu verhindern, daß es aufgrund des Austritts von Füllmaterial 37 aus dem Spalt 36 im Bereich des Überstands 49 zu Verklebungen mit der Innenwand der Chipaufnahme 47 kommt, ist die Innenwand der Chipaufnahme 47 mit einer Antihaftbeschichtung 51 versehen.

Wie aus **Fig. 8** ferner zu ersehen ist, wird zur Verbindung der Leiterbahnen 28 des Chipträgers 21 mit den Kontaktmetallisierungen 33 des Chips 22 die Trägerschicht 23 des Chipträgers 21 über eine Lichtleitfaser 52 unter gleichzeitiger Aufbringung eines Anpreßdrucks mit Laserstrahlung 53 beaufschlagt. Die Laserstrahlung 53 durchdringt das optisch durchlässige Polyimid der Trägerschicht 23 oder einen anderen für Laserstrahlung optisch durchlässigen, als Trägerschicht verwendeten Kunststoff und wird im Bereich der Leiterbahn 28 absorbiert, so daß im Bereich der Verbindungsstelle zwischen der Leiterbahn 28 und der zugeordneten Kontaktmetallisierung 33 die für die thermische Verbindung notwendige Temperatur induziert wird. Dabei wird durch den mit der Lichtleitfaser 52 auf die Trägerschicht 23 aufgebrachten Anpreßdruck möglicherweise zwischen der Leiterbahn 28 und der Kontaktmetallisierung 33 bzw. dem auf die Kontaktmetallisierung 33 aufgebrachten Lotüberzug 24 angeordnetes Füllmaterial 37 verdrängt, so daß die Verbindung nicht durch Füllmaterial 37 beeinträchtigt werden kann.

Falls es zur Erzielung einer planen Oberfläche des auf den Chip 22 applizierten Chipträgers 21 notwendig sein sollte, kann noch ein in **Fig. 8** nicht näher dargestelltes zentrales Stempelwerkzeug zur Erzeugung einer ebenen Anlage des Chipträgers 21 eingesetzt werden.

Neben der vorstehend geschilderten Verbindung der Leiterbahnen 28 des Chipträgers 21 mit den Kontaktmetallisierungen 33 des Chips 22 im Lötverfahren ist es auch möglich, das in **Fig. 8** dargestellten Verbindungsmittel, also die durch Laserenergie beaufschlagte Lichtleitfaser 52, zur Ausführung einer Thermokompressionsverbindung zu verwenden, zu deren Vorbereitung die als Nickelbumps ausgeführten Kontaktmetallisierungen 33 nicht mit dem Lotüberzug 44, sondern mit einem dünnen Goldüberzug versehen werden.

Eine weitere Möglichkeit zur Herstellung der Verbindung zwischen den Leiterbahnen 28 des Chipträgers 21 und den Kontaktmetallisierungen 33 bzw. unmittelbar mit den unpräparierten Aluminiumanschlußflächen 32 des Chips 22 besteht darin, anstatt der in **Fig. 8** dargestellten Lichtleitfaser 52 einen Ultraschalldorn zu verwenden, der mit Ultraschall beaufschlagt wird und die Ultraschallschwingungen über einen verdichteten Bereich der Trägerschicht 23 auf den Verbindungsbereich zwischen den Leiterbahnen 28 und den jeweils zugeordneten Chipanschlußflächen 32 überträgt.

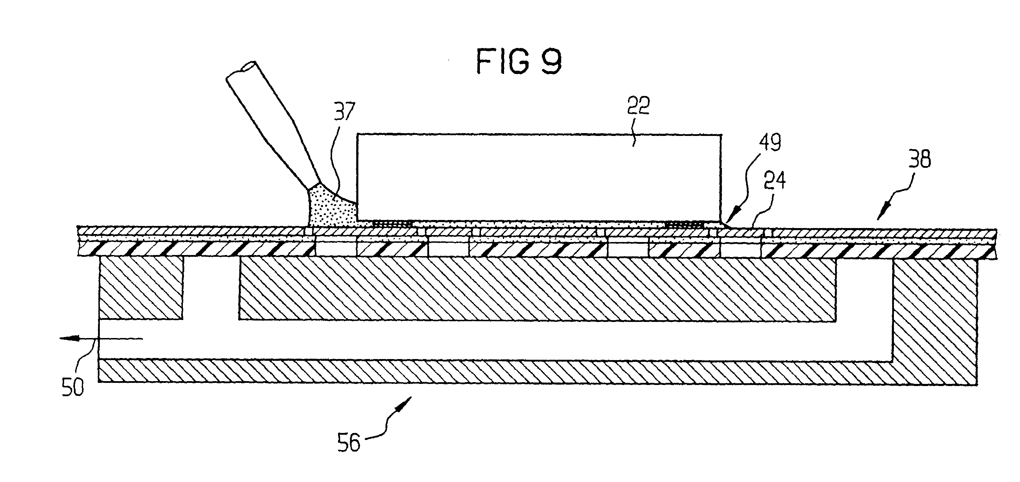

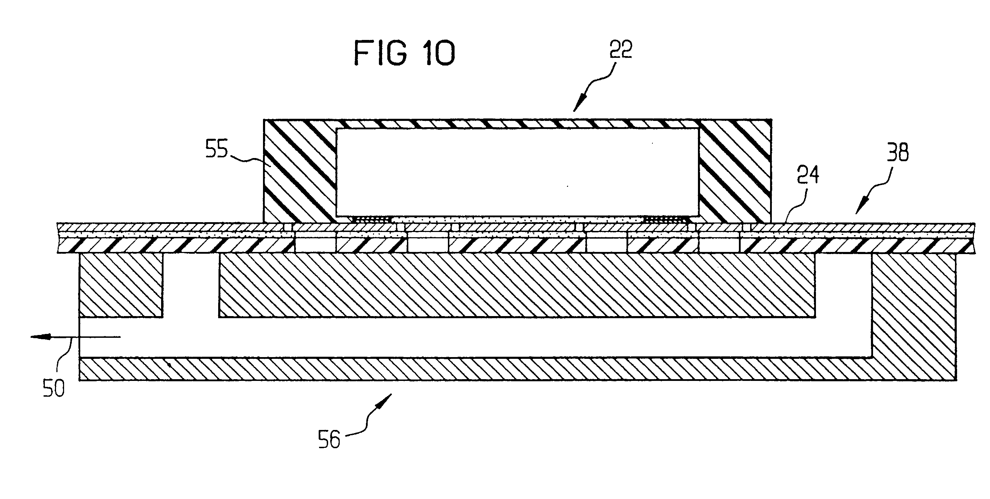

Die **Fig. 9** und **10** zeigen Möglichkeiten einer neben der Anordnung des Füllmaterials 37 im Spalt 36 zwischen dem Chipträger 21 und dem Chip 22 (Underfilling) zusätzlichen mechanischen Stabilisierung des Chipmoduls. Wie **Fig. 9** zeigt, kann hierzu im peripheren Bereich längs des Umfangsrands des Chips 22 im Übergang zum Chipträger 21 zusätzliches Füllmaterial 37 zur Ausbildung eines umlaufenden Stabilisierungsrahmens aufgebracht werden.

**Fig. 10** zeigt ein als "Molding" bekanntes Verfahren, bei dem der Chip mittels einer Kunststoffmasse 55 umkapselt wird.

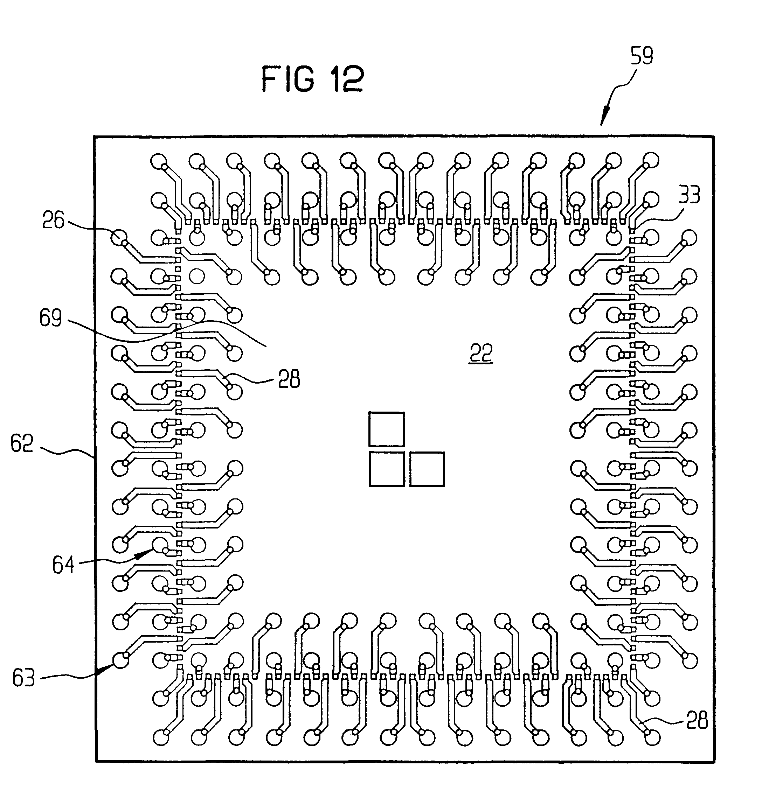

Sowohl die Kunststoffmasse 55 als auch das gemäß **Fig. 9** zusätzlich applizierte Füllmaterial 37 sorgen im Bereich des Überstands 49 des Chipträgers 21 über die Oberfläche des Chips 22 für eine stabilisierende Abstützung. Da sich bei den in den **Fig. 9** und **10** dargestellten Verfahren zur zusätzlichen Stabilisierung der Chipträger-Anordnung, bei denen die Chipträger-Folie 38 auf einer ebenen Fläche durch eine Vakuumeinrichtung 56 gehalten wird, vorstehende Lotmaterialdepots 29, wie in **Fig. 1** dargestellt, als störend erweisen würden, werden in diesen Fällen die Lotmaterialdepots 29 erst nachträglich erzeugt. Hierzu können, wie in **Fig. 11** dargestellt, Lotmaterialformstücke 57 vor oder nach Heraustrennen der mit dem Chip 22 verbundenen Chipträger 21 aus der Chipträger-Folie 38 in die Ausnehmungen 26 plaziert und anschließend zur Ausbildung der Lotmaterialdepots 29 umgeschmolzen werden. Bei dem in **Fig. 11** dargestellten Ausführungsbeispiel sind die Lotmaterialformstücke 57 kugelförmig ausgebildet und werden durch eine Lotkugelplaziereinrichtung 58 in die Ausnehmungen 26 plaziert.

In den **Fig. 12, 13** und **14** sind unterschiedlich ausgebildete Chipmodule 59, 60 und 61 beispielhaft dargestellt. Dabei entspricht die gewählte Ansicht in etwa einem Schnittverlauf zwischen der Trägerschicht 23 und jeweils einer die Leiterbahnen 28 aufweisenden Kontaktschicht 69, 70, 71. **Fig. 12** zeigt das Chipmodul 59 mit einer sogenannten "zweireihigen Fan-Out"-Konfiguration, bei der ausgehend von der peripheren, einreihigen Anordnung der Kontaktmetallisierungen 33 des Chips 22 über die Kontaktschicht 69 eine flächige Umverteilung in einem Chipträger 62 erfolgt, bei der außerhalb der Chipperipherie zwei Reihen 63, 64 von Außenkontaktbereichen 26 angeordnet sind.

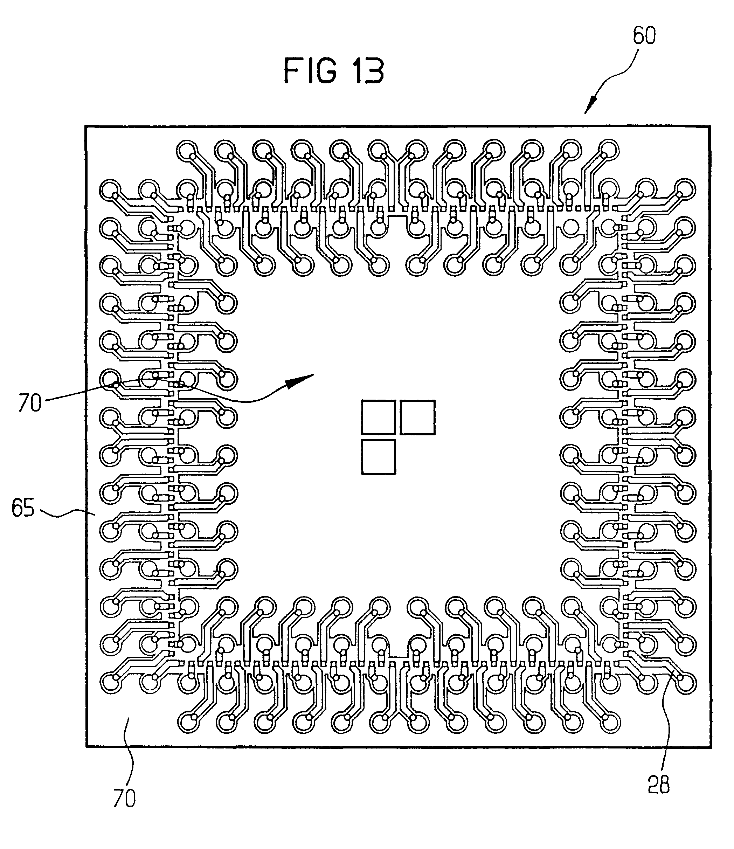

**Fig. 13** zeigt eine übereinstimmende Konfiguration, wobei hier ein Chipträger 65 verwendet wird, bei dessen Kontaktschicht 70 nicht nur die Leiterbahnen 28 aus Kupfer, sondern vielmehr die gesamte Kontaktschicht 70 aus Kupfer besteht, wobei die Leiterbahn 28 durch Ätzfugen vom übrigen Kupfermaterial getrennt ist. Der in **Fig. 13** beispielhaft dargestellte Chipträger 65 zeichnet sich daher durch eine besonders hohe Steifigkeit aus.

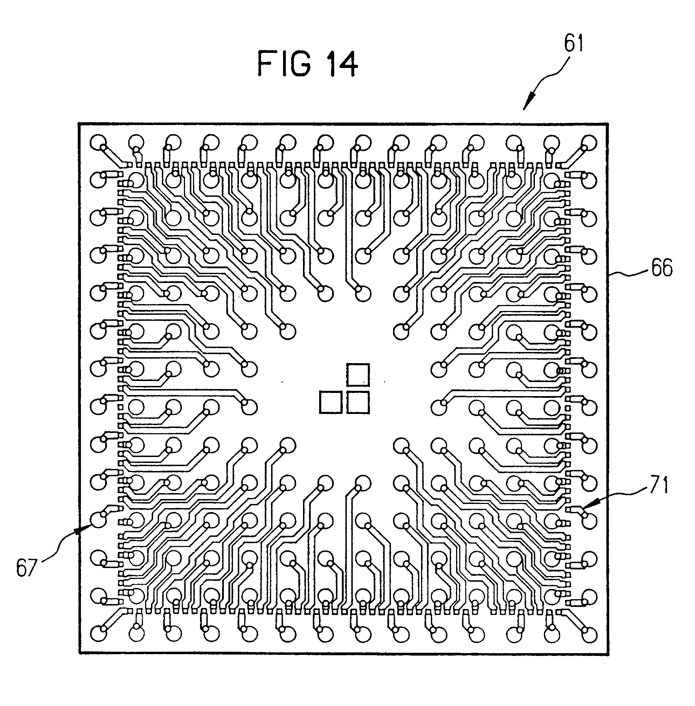

**Fig. 14** zeigt schließlich einen Chipträger 66 mit einer sogenannten einreihigen "Fan-Out"-Konfiguration, bei der lediglich eine Reihe 67 von Außenkontaktbereichen 26 außerhalb der Chipperipherie angeordnet ist und alle übrigen Außenkontaktbereiche 26 sich innerhalb der Chipperipherie verteilt befinden.

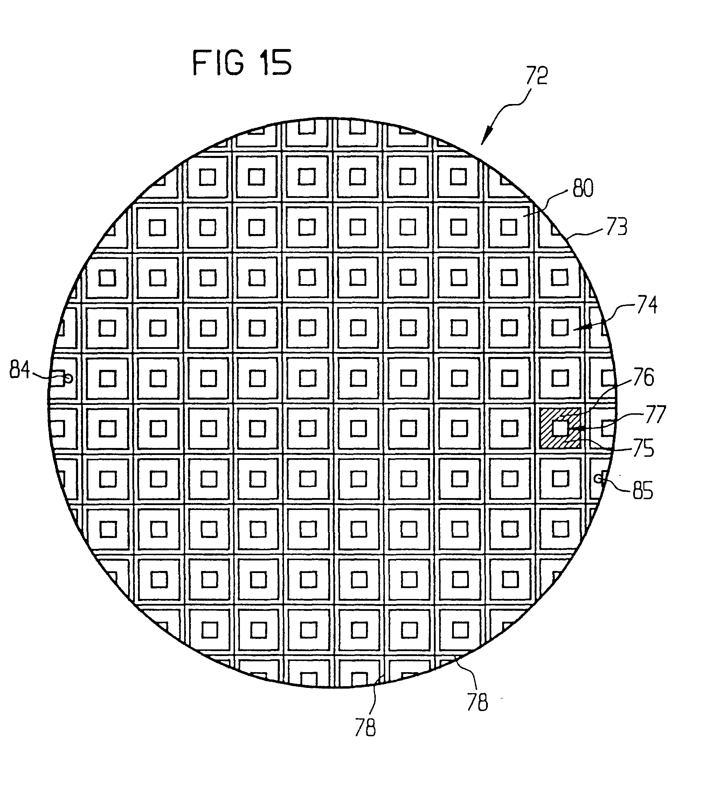

**Fig. 15** zeigt einen Modulverbund 72 mit einem Wafer 73 und einem auf dem Wafer 73 angeordneten Chipträgerverbund 74 mit einer Vielzahl zusammenhängend auf der gemeinsamen Trägerschicht 23 angeordneter Chipträger 76. Wie der Darstellung gemäß **Fig. 15** zu entnehmen ist, weist der Wafer eine Vielzahl zusammenhängend ausgebildeter Chips 75 auf, denen jeweils ein Chipträger 76 aus dem Chipträgerverbund 74 zugeordnet ist. Zu der der Herstellung des in **Fig. 15** dargestellten Modulverbunds 72 nachfolgenden Vereinzelung von Chipmodulen 77, die im vorliegenden Fall aus jeweils einem Chip 75 und einem Chipträger 76 gebildet sind, sind auf dem Wafer 73 Teilungsnuten 78 vorgesehen, längs deren Verlauf der Modulverbund 72 durch Sägen oder auch andere geeignete Trennvorgänge in die Chipmodule 77 vereinzelt werden kann.

Die aus dem Modulverbund 72 vereinzelten Chipmodule 77 können in einer Ausführungsform hinsichtlich ihres Aufbaus im wesentlichen mit dem in **Fig. 1** dargestellten Chipmodul 20 übereinstimmen, mit dem Unterschied, daß der Chipträger 76 abweichend von dem in **Fig. 1** dargestellten Chipträger 21 mit seinen Außenrändern im wesentlichen bündig mit den Chipseitenrändern verläuft und diese nicht, wie in **Fig. 1** dargestellt, seitlich überragt.

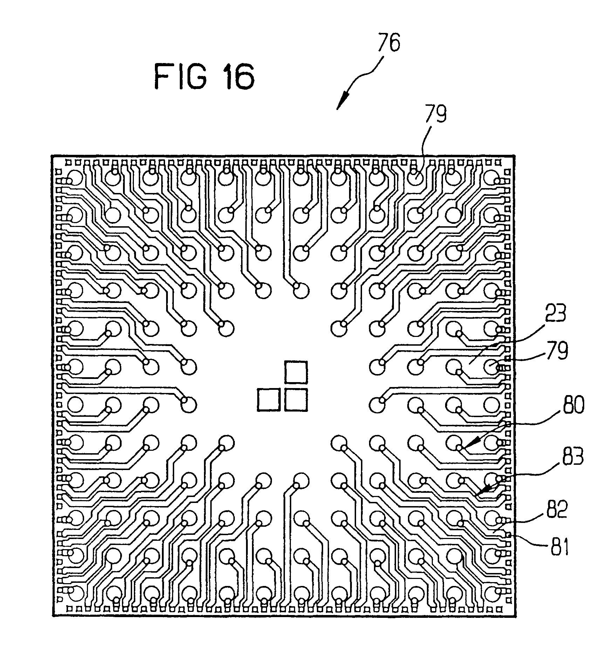

Ein derartiger Chipträger 76 ist in Draufsicht in **Fig. 16** dargestellt und ermöglicht, ausgehend von den Chipkontaktbereichen 81, eine sogenannte "Fan-In"-Verteilung von Anschlußflächen 79 einer Anschlußflächenanordnung 80 auf der Trägerschicht 23 des Chipträgers 76. Die Anschlußflächenanordnung 80 des Chipträgers 76 ist in **Fig. 15** durch einen rahmenartigen, schraffierten Linienverlauf vereinfacht dargestellt.

Abgesehen von dem vorstehend erwähnten Unterschied zum Aufbau des in **Fig. 1** dargestellten Chipmoduls 20, derart, daß zur Herstellung eines Chipmoduls 77 eine im wesentlichen zu der Chipoberfläche bündige Ausbildung des Chipträgers 76 erforderlich ist, können zur Herstellung des in **Fig. 15** dargestellten Modulverbunds sämtliche der in den **Fig. 2** bis **7** dargestellten Verfahrensschritte durchgeführt werden, mit dem Unterschied, daß statt eines einzelnen Chips 22 eine Vielzahl in dem Wafer 73 zusammenhängend ausgebildeter Chips 75 und statt eines einzelnen Chipträgers 21 eine Vielzahl in dem Chipträgerverbund 74 zusammenhängend ausgebildeter Chipträger 76 verwendet werden. Es erfolgt somit die Herstellung von Chipmodulen 77 durch Vereinzelung der Chipmodule 77 aus einem zuvor beispielsweise entsprechend den in den **Fig. 2** bis **7** dargestellten Verfahrensschritten hergestellten Modulverbund 72.

Um bei der großflächigen Applikation des Chipträgerverbunds 74 auf dem Wafer 73 - wie beispielsweise bezogen auf die Herstellung des einzelnen Chipmoduls 20 in **Fig. 7** dargestellt - die Ausbildung von Lufteinschlüssen zwischen dem Chipträgerverbund und der Oberfläche des Wafers 73 zu verhindern, kann der Chipträgerverbund mit in **Fig. 15** nicht näher dargestellten, als Perforationslinien ausgebildeten Teilungslinien versehen sein, die deckungsgleich mit den Teilungslinien 78 des Wafers 73 sind, die einzelnen Chipträger 76 voneinander abteilen und gleichzeitig durch die Perforationen ein Entweichen von Luft zur Verhinderung der vorstehend erwähnten Lufteinschlüsse ermöglichen.

Zur Ermöglichung einer korrekten Relativpositionierung des Chipträgerverbunds 74 zum Wafer 73 mit entsprechenden, in **Fig. 15** dargestellten Überdeckungslagen zwischen den einzelnen Chipträgern 76 und den Chips 75, die eine Kontaktierung zwischen den Chipkontaktbereichen 81 an den Enden von Leiterbahnen 82 von den einzelnen Chipträgern 76 zugeordneten Leiterbahnstrukturen 83 ermöglichen, kann der Wafer 73 auf seiner Oberfläche mit Positionierungsstiften 84, 85 versehen sein, die in korrespondierend ausgebildete, hier nicht näher dargestellte Positionierungsöffnungen in der Trägerschicht 23 des Chipträgerverbunds 74 eingreifen. Die Positionierungsstifte 84, 85 können von überhöht ausgebildeten Bumps im Randbereich des Wafers 73 unvollständig ausgebildeter Chips gebildet sein. Wie die übrigen, hier nicht näher dargestellten Bumps der funktionsfähigen Chips 75 können grundsätzlich die Bumps des Wafers durch beispielsweise autokatalytische Materialabscheidung oder eine Tauchbelotung hergestellt werden.

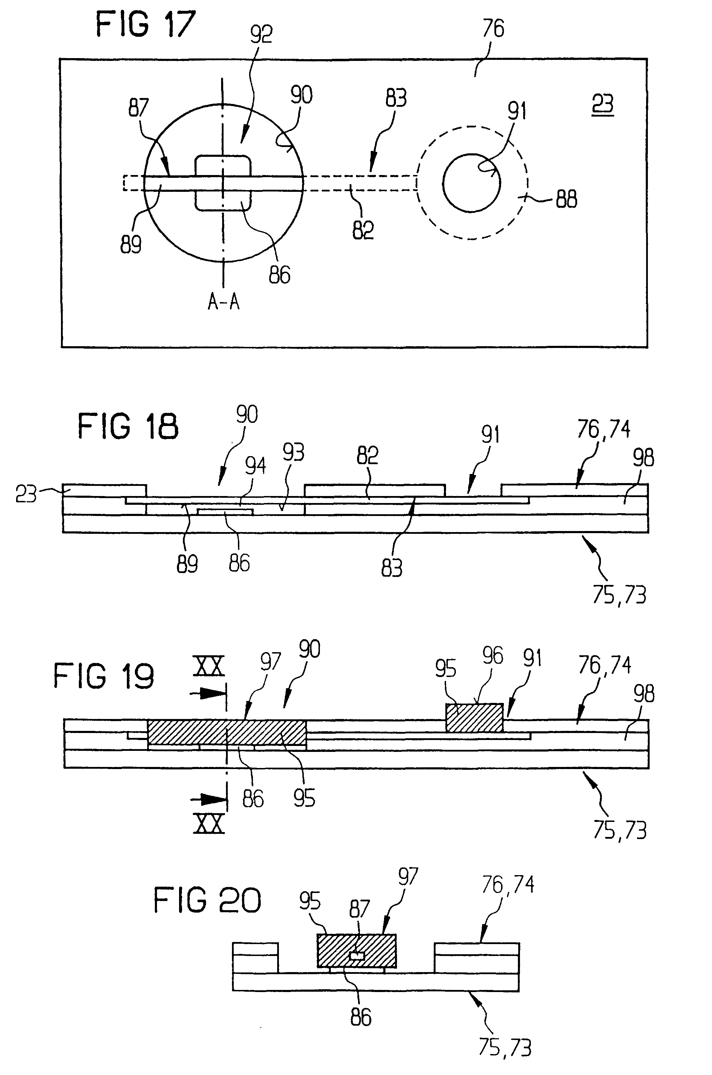

In den **Fig. 17** bis **20** ist eine von der in den **Fig. 2** bis **7** abweichende Herstellung des Verbundes zwischen einem Chip und einem Chipträger bzw. einem Wafer und einem Chipträgerverbund am Beispiel der Verbindung einer Chipanschlußfläche 86 mit einer Leiterbahn 82 eines Chipträgers 76 dargestellt. Wie nachfolgend erläutert wird, ermöglicht der in den **Fig. 17** bis **20** dargestellte Verbindungsaufbau eine besonders kostengünstige Herstellung von Chipmodulen 77 auf Waferebene (**Fig. 15**).

Wie die Draufsicht auf einen ausgeschnittenen Bereich des Chipträgers 76 in **Fig. 17** in einer Zusammenschau mit der entsprechenden Seitenansicht in **Fig. 18** deutlich macht, besteht der Chipträger 76 im vorliegenden Fall aus der Trägerschicht 23 mit einer auf deren Unterseite angeordneten Leiterbahnstruktur 83, von der hier lediglich die eine Leiterbahn 82 dargestellt ist. Die Leiterbahn 82 ist im vorliegenden Fall aus einem Stableiter 87 und einem Kreisflächenleiter 88 zusammengesetzt. Die Leiterbahn 82 ist so auf der Unterseite der Trägerschicht 23 angeordnet, daß sich ein Chipkontaktbereich 89 des Stableiters 87 und der Kreisflächenleiter 88 der Leiterbahn 82 unterhalb einer Öffnung 90 bzw. einer Ausnehmung 91 in der Trägerschicht 23 befinden. Die Ausnehmung 91 ist nach unten durch die Rückseite des Kreisflächenleiters 88 der Leiterbahn 82 begrenzt. Die Öffnung 90 in der Trägerschicht 23 reicht bis an die Rückseite des Stableiters 87 der Leiterbahn 82 und gibt überdies einen den Chipkontaktbereich 89 des Stableiters 87 umgebenden Umgebungsbereich 92 frei, der, wie in **Fig. 17** dargestellt, sich noch über die Chipanschlußfläche 86 hinaus erstreckt.

Wie **Fig. 18** zeigt, ist eine zur Herstellung des Verbunds zwischen dem Chipträgerverbund 74 und dem Wafer 73 vorgesehene Kleberschicht 98 so angeordnet, daß eine im wesentlichen mit der Fläche der Öffnung 90 deckungsgleiche Verbindungsfläche 93 auf der Oberfläche des Wafers 73 bzw. des Chips 75 ausgebildet ist, in deren Innenbereich die Chipanschlußfläche 86 angeordnet ist. Weiterhin wird aus **Fig. 18** deutlich, daß zwischen der Oberfläche der Chipanschlußfläche 86 und der Unterseite des Stableiters 87 der Leiterbahn 82 ein Kontaktspalt 94 ausgebildet ist.

**Fig. 19** zeigt die Ausnehmung 91 im Chipträger 76 des Chipträgerverbunds 74 und die im Umgebungsbereich 92 bis an die Oberfläche des Wafers 73 reichende Öffnung 90 des Chipträgers 76 nach Einbringung eines Verbindungsmaterials 95. Dabei ist die Öffnung 90 im Bereich der Chipanschlußfläche 86 und des Chipkontaktbereichs 89 der Leiterbahn 82 sowie der Kontaktspalt 94 mit dem Verbindungsmaterial 95 ausgefüllt, so daß, wie aus der Schnittdarstellung in **Fig. 20** deutlich wird, ein allseitiger Einschluß der Leiterbahn 82 im Chipkontaktbereich 89 mit sicherer Verbindung zur Chipanschlußfläche 86 die Folge ist. Dieser allseitige Einschluß ist eine Folge des allseitigen Aufwachsens des Verbindungsmaterials 95 beim Abscheidevorgang. Hieraus ergibt sich auch ein Zuwachsen des Kontaktspalts 94.

Als besonderer Vorteil bei dem in den **Fig. 17** bis **20** dargestellten Verbindungsaufbau erweist es sich, daß sowohl die Ausnehmung 91 als auch die Öffnung 90 im Chipträger 76 in ein und demselben Verfahrensschritt mit Verbindungsmaterial 95 befüllt werden können, so daß einerseits Außenkontaktbumps 96 für die äußere Anschlußflächenanordnung 80 des Chipträgers 76 und andererseits Innenverbindungen 97 zwischen dem Wafer 73 bzw. den durch diesen zusammenhängend ausgebildeten Chips 75 und den Chipträgern 76 geschaffen werden.

Die Öffnungen 90 im Chipträgerverbund 74 sind ausreichend groß, so daß die Chipanschlußflächen 86 des Wafers 73 vor der Einbringung von Verbindungsmaterial 95, die beispielsweise durch autokatalytische Abscheidung von Nickel oder dergleichen erfolgen kann, gereinigt und/oder mit einer Beschichtung, beispielsweise Zinkat oder einer Nickel-Zwischenschicht, versehen werden können.

Die Einbringung des Verbindungsmaterials kann auf besonders vorteilhafte Weise durch Eintauchen des Wafers 73 oder Hindurchführen des Wafers 73 in bzw. durch ein Materialbad erfolgen.

Abweichend von der in den **Fig. 17** bis **20** dargestellten stabförmigen Geometrie der Leiterbahn 82 im Bereich der Öffnung 90 sind auch andere Leiterbahngeometrien möglich, die in besonderer Weise das vorbeschriebene Aufwachsen des Verbindungsmaterials beim Abscheidevorgang zur Ausbildung der Verbindung zwischen dem Chipanschluß 86 und der Leiterbahn 82 fördern und nutzen. So kann die Leiterbahn 82 einen ringförmig ausgebildeten Chipkontaktbereich aufweisen, dessen Innendurchmesser so bemessen ist, daß der Verbindungsmaterialaufbau auf der Chipanschlußfläche 86 infolge des Abscheidevorgangs quasi durch den Ring hindurch wächst und so zur Ausbildung der Verbindung beiträgt. Dabei kann der ringförmig ausgebildete Chipkontaktbereich durch den Rand der Öffnung 90 abgedeckt sein oder offenliegen. Insbesondere bei einem durch den Rand der Öffnung 90 in der Trägerschicht 23 abgedeckten ringförmigen Chipkontaktbereich läßt sich eine im wesentlichen zur Oberfläche des Chipträgers 76 bzw. des Chipträgerverbunds 74 bündig ausgebildete Oberfläche der Innenverbindung erzielen, ohne daß hierzu besondere Maßnahmen notwendig wären. Grundsätzlich kann die Öffnung 90 größer oder kleiner als die Chipanschlußfläche, aber auch gleich groß ausgebildet sein.

Weitere Möglichkeiten, die Ausbildung der Oberfläche der Innenverbindung durch die Gestaltung der Leiterbahn 82 in deren Chipkontaktbereich 89 über die Geometrie der Leiterbahn 82 zu beeinflussen, bestehen darin, die Leiterbahn 82 in diesem Bereich rahmenartig quadratisch, schlitzförmig oder auch kreuzartig auszubilden.

## Patentansprüche

1. Chipmodul mit einem Chipträger (21) und mindestens einem Chip (22, 75), wobei der Chipträger als Folie ausgebildet ist mit einer Trägerschicht (23) aus Kunststoff und einer Leiterbahnstruktur mit Leiterbahnen (28), wobei die Leiterbahnen auf ihrer Vorderseite mit Anschlußflächen (32) des Chips verbunden sind und auf ihrer Rückseite Außenkontaktbereiche zur Ausbildung einer flächig verteilten Anschlußflächenanordnung zur Verbindung des Chipmoduls mit einem elektronischen Bauelement oder einem Substrat aufweisen, wobei die Leiterbahnen in einer Ebene auf der dem Chip zugewandten Chipkontaktseite der Trägerschicht verlaufen und die Außenkontaktbereiche durch Ausnehmungen in der Trägerschicht gebildet sind, die sich gegen die Rückseite der Leiterbahnen erstrecken
**dadurch gekennzeichnet,**
**daß** sich die Trägerschicht (23) über die Chipoberfläche des Chips (22, 75) erstreckt, der Chipträger (21) unter zwischenliegender Anordnung eines Füllstoffs (37) mit dem Chip (22, 75) verbunden ist, und die Trägerschicht (23) sich über den Bereich der Anschlußflächen (32) des Chips (22, 75) erstreckt.

2. Chipmodul nach Anspruch 1,
**dadurch gekennzeichnet,**
**daß** die Trägerschicht (23) über den Bereich der Anschlußflächen (32) des Chips hinweg kontinuierlich ausgebildet ist, derart, daß die Trägerschicht (23) im Bereich der Anschlußflächen (32) des Chips geschlossen ist.

3. Chipmodul nach Anspruch 1,
**dadurch gekennzeichnet,**
**daß** die Trägerschicht (23) in einem Überdeckungsbereich mit den Anschlußflächen (32, 86) des Chips (22, 75) Öffnungen (90) aufweist, die sich gegen die Rückseite (27) der Leiterbahnen (82) erstrecken und zur Aufnahme von die Leiterbahnen mit den zugeordneten Anschlußflächen elektrisch verbindendem Verbindungsmaterial (95) dienen.

4. Chipmodul nach Anspruch 3,
**dadurch gekennzeichnet,**
**daß** die Leiterbahnen (82) im Bereich der Öffnungen (90) so angeordnet sind, daß ein Chipkontaktbereich (89) der Leiterbahnen (82) die Anschlußflächen (32, 86) des Chips (22, 75) nur teilweise überdeckt, oder der Chipkontaktbereich (89) der Leiterbahnen (82) benachbart zu den Anschlußflächen (32) liegt.

5. Chipmodul nach einem oder mehreren der Ansprüche 1 bis 4,
**dadurch gekennzeichnet,**
**daß** längs der Peripherie des Chips (22) verlaufend ein Stützrahmen vorgesehen ist.

6. Chipmodul nach einem oder mehreren der Ansprüche 1 bis 4,
**gekennzeichnet durch**
einen die Seitenflächen des Chips (22) mit einem die Chipoberfläche überragenden Überstand (49) des Chipträgers (21) verbindenden Verguß.

7. Chipmodul nach einem oder mehreren der vorangehenden Ansprüche,
**dadurch gekennzeichnet,**
**daß** die Außenkontaktbereiche (26) mit Lotmaterial (42) versehen sind, dessen Schmelzpunkt niedriger ist als die zur thermischen Verbindung zwischen den Kontaktflächenmetallisierungen (33) des Chips (22) und den Leiterbahnen (28) des Chipträgers (21) notwendige Temperatur.

8. Modulverbund mit einer Chipträgeranordnung und einer Chipanordnung, insbesondere einem Wafer, mit einer Vielzahl zusammenhängend ausgebildeter Chipmodule nach einem oder mehreren der Ansprüche 1 bis 6, bei dem sowohl die Chipträger als auch Chips jeweils einen Verbund bilden.

9. Verfahren zur Herstellung eines Chipmoduls nach einem oder mehreren der Ansprüche 1 bis 7,
**gekennzeichnet durch**
die Verfahrensschritte:
- Auftragen eines fließfähigen Füllmaterials (37) auf die Chipoberfläche oder die Chipkontaktseite (35) des Chipträgers (21);
- einander Andrücken einer Chipkontaktseite (35) des Chipträgers (21) und der Chipoberfläche und Kontaktierung der Leiterbahnen (28) des Chipträgers (21) mit den zugeordneten Kontaktmetallisierungen (33) des Chips (22) **durch** eine von der Seite der Trägerschicht, welche der Seite, die die Leiterbahnanordnung aufweist, gegenüberliegt, ausgehenden, rückwärtigen Energiebeaufschlagung der Leiterbahnen (28) unter Zwischenlage der Trägerschicht (23) bei gleichzeitiger Verdrängung des Füllmaterials (37).

10. Verfahren zur Herstellung eines Chipmoduls nach einem oder mehreren der Ansprüche 1 bis 7,
**gekennzeichnet durch**
die Verfahrensschritte:
- Bereitstellung eines Chipträgers, der auf der dem Chip (22) zugewandten Chipkontaktseite (35) mit einer Kleberschicht versehen ist;
- einander Andrücken der Chipkontaktseite (35) des Chipträgers (21) und der Chipoberfläche und Kontaktierung der Leiterbahnen (28) des Chipträgers (21) mit den zugeordneten Kontaktmetallisierungen (33) des Chips (22) **durch** eine rückwärtige Energiebeaufschlagung der Leiterbahnen (28) unter Zwischenlage der Trägerschicht (23) bei gleichzeitiger Verdrängung des Klebermaterials (37).

11. Verfahren zur Herstellung eines Chipmoduls nach einem oder mehreren der Ansprüche 1 bis 7,
**gekennzeichnet durch**
die Verfahrensschritte:
- Herstellung eines Modulverbunds (72) mit einem Chipträgerverbund (74) und einem Chipverbund (73) nach Anspruch 8;
- Herstellung einer Mehrzahl einzelner Chipmodule (77) **durch** Vereinzelung von Einheiten aus mindestens einem Chip (75) und einem damit kontaktierten Chipträger (76) aus dem Modulverbund (73).

12. Verfahren nach Anspruch 11,
**gekennzeichnet durch**
die folgenden Verfahrensschritte zur Herstellung des Modulverbunds (72):
- Bereitstellung eines Wafers (73), der auf den Anschlußflächen (86) mit erhöhten Kontaktmetallisierungen versehen ist, und eines Chipträgerverbunds (74) mit einer Vielzahl von auf einer gemeinsamen Trägerschicht (23) angeordneten Leiterbahnstrukturen (83) mit Leiterbahnen (82);
- Auftragen eine fließfähigen Füllmaterials (37) auf die Kontaktfläche des Wafers oder die Chipkontaktseite des Chipträgerverbunds;
- Relativpositionierung des Wafers und des Chipträgerverbunds, derart, daß sich eine Überdeckungslage zwischen den Kontaktmetallisierungen des Wafers und Kontaktbereichen (89) der zugeordneten Leiterbahnen (82) der Leiterbahnstrukturen einstellt;
- Herstellung einer flächigen Verbindung zwischen dem Wafer und dem Chipträgerverbund und Kontaktierung der Kontaktmetallisierungen des Wafers mit den zugeordneten Leiterbahnen des Chipträgerverbunds.

13. Verfahren nach Anspruch 11,
**gekennzeichnet durch**
die folgenden Verfahrensschritte zur Herstellung des Modulverbunds (72):
- Bereitstellung eines Wafers (73), der auf den Anschlußflächen (86) mit erhöhten Kontaktmetallisierungen versehen ist, und eines Chipträgerverbunds (74) mit einer Vielzahl von auf einer gemeinsamen Trägerschicht (23) angeordneten Leiterbahnstrukturen (83) mit Leiterbahnen (82) und einer Kleberschicht (37) auf der Chipkontaktseite der Trägerschicht (23);
- Relativpositionierung des Wafers (73) und des Chipträgerverbunds (74), derart, daß sich eine Überdeckungslage zwischen den Kontaktmetallisierungen des Wafers und Kontaktbereichen (89) der zugeordneten Leiterbahnen (82) der Leiterbahnstrukturen einstellt;
- Herstellung einer flächigen Verbindung zwischen dem Wafer (73) und dem Chipträgerverbund (74) und Kontaktierung der Kontaktmetallisierungen des Wafers mit den zugeordneten Leiterbahnen des Chipträgerverbunds.

14. Verfahren nach Anspruch 12 oder 13,
**dadurch gekennzeichnet,**
**daß** die Kontaktierung der Kontaktmetallisierungen mit den Leiterbahnen (82) durch die Trägerschicht (23) des Chipträgerverbunds (74) erfolgt.

15. Verfahren nach einem oder mehreren der Ansprüche 12 bis 14,
**dadurch gekennzeichnet,**
**daß** als Hilfsmittel zur Relativpositionierung des Wafers (73) gegenüber dem Chipträgerverbund (74) der Wafer mit mindestens zwei Positionierungsstiften (84, 85) versehen ist, die in korrespondierend ausgebildete Positionierungsöffnungen in der Trägerschicht des Chipträgerverbunds (74) eingreifen.

16. Verfahren nach Anspruch 11,
**gekennzeichnet durch**
die folgenden Verfahrensschritte zur Herstellung des Modulverbunds (72):
- Bereitstellung eines Wafers (73) und eines Chipträgerverbunds (74) mit einer Vielzahl auf einer gemeinsamen Trägerschicht (23) angeordneter Leiterbahnstrukturen (83) mit Leiterbahnen (82), wobei die Trägerschicht (23) die Rückseite des Chipkontaktbereichs (89) der Leiterbahnen (82) freigebende Öffnungen aufweist;
- Auftragen eines fließfähigen Füllmaterials (37) auf die Kontaktoberfläche des Wafers (73) oder die Chipkontaktseite des Chipträgerverbunds (74), derart, daß die Anschußflächen (86) des Wafers bzw. die Öffnungen (90) der Trägerschicht (23) frei bleiben;
- Relativpositionierung des Wafers (73) und des Chipträgerverbunds (74), derart, daß sich eine Überdeckungslage zwischen den Anschlußflächen des Wafers und den Öffnungen in der Trägerschicht des Chipträgerverbunds einstellt;
- Herstellung einer flächigen Verbindung zwischen dem Wafer (73) und dem Chipträgerverbund (74) und Kontaktierung der Anschlußflächen des Wafers mit den Chipkontaktbereichen der zugeordneten Leiterbahnen **durch** Einbringung von Verbindungsmaterial (95) in die Öffnungen (90) der Trägerschicht (23) des Chipträgerverbunds.

17. Verfahren nach Anspruch 11,
**gekennzeichnet durch**
die folgenden Verfahrensschritte zur Herstellung des Modulverbunds (72):
- Bereitstellung eines Wafers (73) und eines Chipträgerverbunds (74) mit einer Vielzahl auf einer gemeinsamen Trägerschicht (23) angeordneter Leiterbahnstrukturen (83) mit Leiterbahnen (82), wobei die Trägerschicht (23) auf ihrer Chipkontaktseite mit einer Kleberschicht (37) versehen ist und die Rückseite des Chipkontaktbereichs (89) der Leiterbahnen (82) freigebende Öffnungen aufweist;
- Relativpositionierung des Wafers (73) und des Chipträgerverbunds (74), derart, daß sich eine Überdeckungslage zwischen den Anschlußflächen des Wafers und den Öffnungen (90) in der Trägerschicht (23) des Chipträgerverbunds (74) einstellt;
- Herstellung einer flächigen Verbindung zwischen dem Wafer (73) und dem Chipträgerverbund (74) und Kontaktierung der Anschlußflächen des Wafers mit den Chipkontaktbereichen der zugeordneten Leiterbahnen **durch** Einbringung von Verbindungsmaterial (95) in die Öffnungen (90) der Trägerschicht (23) des Chipträgerverbunds.

18. Verfahren nach Anspruch 16 oder 17,
**dadurch gekennzeichnet,**
**daß** die Kontaktierung durch eine Abscheidung von Verbindungsmaterial (95) in den Öffnungen (90) der Trägerschicht (23) erfolgt.

19. Verfahren nach Anspruch 18,
**dadurch gekennzeichnet**,
die Kontaktierung durch stromlose Abscheidung von Verbindungsmaterial in einem Materialbad erfolgt.

20. Verfahren nach Anspruch 19,
**dadurch gekennzeichnet**
**daß** als Materialbad ein Nickelbad verwendet wird.

21. Verfahren nach Anspruch 16 oder 17,
**dadurch gekennzeichnet,**
**daß** die Kontaktierung durch Einbringung von Lotmaterial in die Öffnungen (90) der Trägerschicht (23) erfolgt.

22. Verfahren nach Anspruch 16 oder 17,
**dadurch gekennzeichnet,**
**daß** die Kontaktierung durch Einbringung von leitfähigem Kleber in die Öffnungen (90) der Trägerschicht (23) erfolgt.

23. Verfahren nach einem oder mehreren der Ansprüche 16 bis 22,
**dadurch gekennzeichnet,**
**daß** gleichzeitig mit der Einbringung von Verbindungsmaterial (95) in die Öffnungen (90) der Trägerschicht (23) eine Einbringung von Verbindungsmaterial in die Ausnehmungen (91) der Trägerschicht erfolgt.

24. Verfahren nach einem oder mehreren der vorangehenden Ansprüche,
**dadurch gekennzeichnet,**
**daß** der Wafer (73) auf seiner Rückseite mit einer Deckschicht versehen wird.

25. Verfahren nach Anspruch 24,
**dadurch gekennzeichnet,**
**daß** zur Erzeugung der Deckschicht ein Epoxyd-Material auf die Rückseite des Wafers (73) aufgebracht wird.

26. Verfahren nach Anspruch 24,
**dadurch gekennzeichnet,**
**daß** zur Erzeugung der Deckschicht eine Folie auf der Rückseite des Wafers (73) aufgebracht wird.

27. Verfahren nach einem oder mehreren der Ansprüche 11 bis 26,
**dadurch gekennzeichnet,**
**daß** die Vereinzelung von Chipmodulen (77) aus dem Modulverbund (72) durch Trennung aneinander angrenzender Chipmodule längs definierter Trennlinien (78) erfolgt.

28. Verfahren nach Anspruch 27,
**dadurch gekennzeichnet,**
**daß** die Trennung mittels Sägen erfolgt.

29. Verfahren nach einem oder mehreren der Ansprüche 11 bis 26,
**dadurch gekennzeichnet,**
**daß** vor der Vereinzelung über die Leiterbahnstruktur (83) des Chipträgerverbunds (74) eine elektrische Überprüfung des Wafers (73) erfolgt.

30. Verfahren nach Anspruch 16 oder 17,
**dadurch gekennzeichnet,**
**daß** vor der Vereinzelung von Chipmodulen (77) aus dem Modulverbund (72) die Einbringung von Lotmaterial (95) in die Ausnehmungen (91) in der Trägerschicht (23) des Chipträgerverbunds (74) erfolgt.

31. Verfahren nach einem oder mehreren der vorangehenden Ansprüche,
**dadurch gekennzeichnet,**
**daß** ein zur Verbindung des Chipträgers (21) bzw. des Chipträgerverbunds (74) mit der Chipoberfläche bzw. der Waferoberfläche notwendiger Verbindungsdruck mittels Vakuum erzeugt wird.

32. Verfahren nach einem oder mehreren der vorangehenden Ansprüche,
**dadurch gekennzeichnet,**
**daß** die Außenkontaktbereiche (26, 91) und/oder die Öffnungen (90) in einem Schablonenauftragsverfahren mit Lotmaterial (42, 95) versehen werden, wobei die Trägerschicht in einem nachfolgenden Umschmelzverfahren zur Erzeugung von Lotmaterialdepots (29) als Lötstopmaske dient.

33. Verfahren nach einem oder mehreren der vorangehenden Ansprüche,
**dadurch gekennzeichnet,**
**daß** die Außenkontaktbereiche (26, 91) in einem Bestückungsverfahren mit Lotmaterialformstücken (57) versehen werden.

34. Verfahren nach einem oder mehreren der vorangehenden Ansprüche,
**dadurch gekennzeichnet,**
**daß** die Verbindung zwischen den Kontaktmetallisierungen (33) des Chips (22) bzw des Wafers (73) und den Leiterbahnen (28, 82) des Chipträgers (21) bzw. des Chipträgerverbunds (74) mit einem Lötverfahren erfolgt.

35. Verfahren nach einem oder mehreren der Ansprüche 1 bis 34,
**dadurch gekennzeichnet,**
**daß** die Verbindung zwischen den Kontaktmetallisierungen (33) des Chips (22) bzw. des Wafers (73) und den Leiterbahnen (28, 82) des Chipträgers (21) bzw. des Chipträgerverbunds (74) mit einem Thermokompressionsverfahren erfolgt.

36. Verfahren nach einem oder mehreren der Ansprüche 1 bis 34,
**dadurch gekennzeichnet,**
**daß** die Verbindung zwischen den Kontaktmetallisierungen (33) des Chips (22) bzw. des Wafers (73) und den Leiterbahnen (28, 82) des Chipträgers (21) bzw. des Chipträgerverbunds (74) mit einem Ultraschallverfahren erfolgt.

## Claims

1. Chip module with a chip carrier (21) and at least one chip (22, 75), wherein the chip carrier is designed as a sheet with a carrier layer (23) of plastics material and a conductor path structure with conductor paths (28), wherein the conductor paths are connected on their front to attachment faces (32) of the chip and have, on their rear side, external bonding regions for forming a flatly distributed attachment face arrangement for connection of the chip module to an electronic component or a substrate, wherein the conductor paths extend in a plane on the chip bonding side of the carrier layer facing the chip, and the external bonding regions are formed by recesses in the carrier layer which extend toward the rear side of the conductor paths, **characterised in that** the carrier layer (23) extends over the chip surface of the chip (22, 75), the chip carrier (21) is connected to the chip (22, 75) with interposition of a filling material (37) and the carrier layer (23) extends over the region of the attachment faces (32) of the chip (22,75).

2. Chip module according to claim 1, **characterised in that** the carrier layer (23) is designed to be continuous over the region of the attachment faces (32) of the chip in such a way that the carrier layer (23) is closed in the region of the attachment faces (32).

3. Chip module according to claim 1, **characterised in that** the carrier layer (23) has, in an overlap region with the attachment faces (32, 86) of the chip (22, 75), orifices (90) which extend toward the rear side (27) of the conductor paths (82) and serve to receive connecting material (95) electrically connecting the conductor paths to the associated attachment faces.

4. Chip module according to claim 3, **characterised in that** the conductor paths (82) are arranged in the region of the orifices (90) in such a way that they only partially overlap the attachment faces (32, 86) of the chip (22, 75) with a chip bonding region (89) or the chip bonding region (89) of the conductor paths (82) is adjacent to the attachment faces (32).

5. Chip module according to one or more of claims 1 to 4, **characterised in that** a supporting frame extending along the periphery of the chip (22) is provided.

6. Chip module according to one or more of claims 1 to 4, **characterised by** a casting compound which connects the lateral faces of the chip (22) to a projection (49) of the chip carrier (21) protruding beyond the chip surface.

7. Chip module according to one or more of the preceding claims, **characterised in that** the external bonding regions (26) are provided with solder material (42) of which the melting point is lower than the temperature required for the thermal connection between the contact face metallizations (33) of the chip (22) and the conductor paths (28) of the chip carrier (21).

8. Module assembly with a chip carrier assembly and a chip assembly, in particular a wafer, with a plurality of coherently formed chip modules, according to one or more of claims 1 to 6 in which both the chip carriers and chips form a respective assembly.

9. Process for producing a chip module according to one or more of claims 1 to 7, **characterised by** the process steps of:
- application of a flowing filling material (37) to the chip surface or the chip bonding side (35) of the chip carrier (21);
- pressing together of a chip bonding side (35) of the chip carrier (21) and the chip surface and bonding of the conductor paths (28) of the chip carrier (21) with the associated contact metallizations (33) of the chip (22) by backward energy loading of the conductor paths (28) issuing from the side of the carrier layer opposing the side with the conductor path arrangement with interposition of the carrier layer (23) and simultaneous displacement of the filling material (37).

10. Process for producing a chip module according to one or more of claims 1 to 7, **characterised by** the process steps of:
- preparing a chip carrier which is provided with an adhesive layer on the chip bonding side (35) facing the chip (22);
- pressing together of the chip bonding side (35) of the chip carrier (21) and the chip surface and bonding of the conductor paths (28) of the chip carrier (21) with the associated contact metallizations (33) of the chip (22) by backward energy loading of the conductor paths (28) with interposition of the carrier layer (23) and simultaneous displacement of the adhesive material (37).

11. Process for producing a chip module according to one or more of claims 1 to 7, **characterised by** the process steps of:
- producing a module assembly (72) with a chip carrier assembly (74) and chip assembly (73) according to claim 8;
- producing a plurality of individual chip modules (77) by isolating units consisting of at least one chip (75) and one chip carrier (76) bonded therewith from the module assembly (73).

12. Process according to claim 11, **characterised by** the following process steps for producing the module assembly (72) :
- preparation of a wafer (73) provided with raised contact metallizations on the attachment faces (86) and of a chip carrier assembly (74) with a plurality of conductor path structures (83) with conductor paths (82) arranged on a common carrier layer (23);
- application of a flowing filling material (37) to the bonding surface of the wafer or the chip bonding side of the chip carrier assembly;
- relative positioning of the wafer and of the chip carrier assembly so as to adjust an overlap position between the contact metallizations of the wafer and bonding regions (89) of the associated conductor paths (82) of the conductor path structures;
- production of a flat connection between the wafer and the chip carrier assembly and bonding of the contact metallizations of the wafer with the associated conductor paths of the chip carrier assembly.

13. Process according to claim 11, **characterised by** the following process steps for producing the module assembly (72) :
- preparation of a wafer (73) provided with raised contact metallizations on the attachment faces (86) and of a chip carrier assembly (74) with a plurality of conductor path structures (83) with conductor paths (82) arranged on a common carrier layer (23) and of an adhesive layer (37) on the chip bonding side of the carrier layer (23) ;
- relative positioning of the wafer (73) and of the chip carrier assembly (74) so as to adjust an overlap position between the contact metallizations of the wafer and bonding regions (89) of the associated conductor paths (82) of the conductor path structures;
- production of a flat connection between the wafer (73) and the chip carrier assembly (74) and bonding of the contact metallizations of the wafer with the associated conductor paths of the chip carrier assembly.

14. Process according to claim 12 or 13, **characterised in that** the bonding of the contact metallizations with the conductor paths (82) is achieved by the carrier layer (23) of the chip carrier assembly (74).

15. Process according to one or more of claims 12 to 14, **characterised in that**, as an aid to the relative positioning of the wafer (73) with respect to the chip carrier assembly (74), the wafer is provided with at least two positioning pins (84, 85) which engage in correspondingly formed positioning orifices in the carrier layer of the chip carrier assembly (74).

16. Process according to claim 11, **characterised by** the following process steps for producing the module assembly (72) :
- preparation of a wafer (73) and a chip carrier assembly (74) with a plurality of conductor path structures (83) with conductor paths (82) arranged on a common carrier layer (23), wherein the carrier layer (23) has orifices exposing the rear side of the chip bonding region (89) of the conductor paths (82);
- application of a flowing filling material (37) to the bonding surface of the wafer (73) or the chip bonding side of the chip carrier assembly (74) so the attachment faces (86) of the wafer or the orifices (90) of the carrier layer (23) are exposed;
- relative positioning of the wafer (73) and the chip carrier assembly (74) so as to adjust an overlap position between the attachment faces of the wafer and the orifices in the carrier layer of the chip carrier assembly;
- production of a flat connection between the wafer (73) and the chip carrier assembly (74) and bonding of the attachment faces of the wafer with the chip bonding regions of the associated conductor paths by introduction of connecting material (95) into the orifices (90) in the carrier layer (23) of the chip carrier assembly.

17. Process according to claim 11, **characterised by** the following process steps for producing the module assembly (72) :
- preparation of a wafer (73) and a chip carrier assembly (74) with a plurality of conductor path structures (83) with conductor paths (82) arranged on a common carrier layer (23), wherein the carrier layer (23) is provided with an adhesive layer (37) on its chip bonding side and has orifices exposing the rear side of the chip bonding region (89) of the conductor paths (82);
- relative positioning of the wafer (73) and the chip carrier assembly (74) so as to adjust an overlap position between the attachment faces of the wafer and the orifices (90) in the carrier layer (23) of the chip carrier assembly (74) ;
- production of a flat connection between the wafer (73) and the chip carrier assembly (74) and bonding of the attachment faces of the wafer with the chip bonding regions of the associated conductor paths by introduction of connecting material (95) into the orifices (90) in the carrier layer (23) of the chip carrier assembly.

18. Process according to claim 16 or 17, **characterised in that** bonding is effected by deposition of connecting material (95) in the orifices (90) in the carrier layer (23).

19. Process according to claim 18, **characterised in that** bonding is effected by current-free deposition of connecting material in a bath of material.

20. Process according to claim 19, **characterised in that** a bath of nickel is used as a bath of material.

21. Process according to claim 16 or 17, **characterised in that** bonding is effected by introduction of solder material into the orifices (90) in the carrier layer (23).

22. Process according to claim 16 or 17, **characterised in that** bonding is effected by introduction of conductive adhesive into the orifices (90) in the carrier layer (23).

23. Process according to one or more of claims 16 to 22, **characterised in that** connecting material is introduced into the recesses (91) in the carrier layer simultaneously with the introduction of connecting material (95) into the orifices (90) in the carrier layer (23).

24. Process according to one or more of the preceding claims, **characterised in that** the wafer (73) is provided with a surface layer on its rear side.

25. Process according to claim 24, **characterised in that** an epoxy resin material is applied to the rear side of the wafer (73) to produce the surface layer.

26. Process according to claim 24, **characterised in that** a sheet is applied to the rear side of the wafer (73) to produce the surface layer.

27. Process according to one or more of claims 11 to 26, **characterised in that** the isolation of chip modules (77) from the module assembly (72) is effected by separating mutually adjacent chip modules along defined parting lines (78).

28. Process according to claim 27, **characterised in that** separation is effected by sawing.

29. Process according to one or more of claims 11 to 26, **characterised in that** electrical testing of the wafer (73) is effected prior to isolation via the conductor path structure (83) of the chip carrier assembly (74).

30. Process according to claim 16 or 17, **characterised in that** solder material (95) is introduced into the recesses (91) in the carrier layer (23) of the chip carrier assembly (74) prior to isolation of chip modules (77) from the module assembly (72).

31. Process according to one or more of the preceding claims, **characterised in that** a connecting pressure required to connect the chip carrier (21) or the chip carrier assembly (74) to the chip surface or the wafer surface is produced by vacuum.

32. Process according to one or more of the preceding claims, **characterised in that** the external bonding regions (26, 91) and/or the orifices (90) are provided with solder material (42, 95) by a template application process, the carrier layer serving as a solder resisting mask in a subsequent reflow process for producing deposits of solder material (29).

33. Process according to one or more of the preceding claims, **characterised in that** the external bonding regions (26, 91) are provided with shaped pieces of solder material (57) by an in-line process.

34. Process according to one or more of the preceding claims, **characterised in that** the connection between the contact metallizations (33) of the chip (22) or of the wafer (73) and the conductor paths (28, 82) of the chip carrier (21) or of the chip carrier assembly (74) is produced by a soldering process.

35. Process according to one or more of claims 1 to 34, **characterised in that** the connection between the contact metallizations (33) of the chip (22) or of the wafer (73) and the conductor paths (28, 82) of the chip carrier (21) or of the chip carrier assembly (74) is produced by a thermocompression process.

36. Process according to one or more of claims 1 to 34, **characterised in that** the connection between the contact metallizations (33) of the chip (22) or of the wafer (73) and the conductor paths (28, 82) of the chip carrier (21) or of the chip carrier assembly (74) is produced by an ultrasonic process.

## Revendications

1. Module à puce avec un support de puce (21) et au moins une puce (22, 75), le support de puce étant réalisé sous la forme d'une feuille et avec une couche support (23) en matière synthétique et une structure à pistes conductrices comportant des pistes conductrices (28), les pistes conductrices sur leur face avant étant reliées à des surfaces de raccordement (32) de la puce et sur leurs faces arrières présentant des zones de contact extérieures pour former un agencement de surface de raccordement réparti dans un plan, pour assurer la liaison du module à puce à un composant électronique ou à un substrat, les pistes conductrices s'étendant dans un plan sur la face de contact de puce, tournée vers la puce, de la couche support et les zones de contact extérieures étant formées par des évidements ménagés dans la couche support, qui s'étendent jusqu'à la face arrière des pistes conductrices,
**caractérisé en ce que**
la couche support (23) s'étend sur la surface de la puce (22, 75), le support de puce (21) étant relié à la puce (22, 75) avec agencement intermédiaire d'une matière de remplissage (37), et la couche support (23) s'étendant sur la zone des surfaces de raccordement (32) de la puce (22, 75).

2. Module à puce selon la revendication 1, **caractérisé en ce que** la couche support (23) s'étend en continu au-delà de la zone des surfaces de raccordement (32) de la puce, de manière que la couche support (23) soit fermée dans la zone des surfaces de raccordement (32) de la puce.

3. Module à puce selon la revendication 1, **caractérisé en ce que** la couche support (23) présente, dans une zone de recouvrement avec les surfaces de raccordement (32, 86) de la puce (22, 75), des ouvertures (90) s'étendant jusqu'à la face arrière (27) des pistes conductrices (82) et servant à loger du matériau de liaison (95) reliant électriquement les pistes conductrices aux surfaces de raccordement associées.

4. Module à puce selon la revendication 3, **caractérisé en ce que** les pistes conductrices (82) sont disposées dans la zone des ouvertures (90), de manière qu'une zone de contact de puce (89) des pistes conductrices (82) ne couvre les surfaces de raccordement (32, 86) de la puce (22, 75) que partiellement, ou bien que la zone de contact de puce (89) des pistes conductrices (82) est disposée au voisinage des surfaces de raccordement (32).

5. Module à puce selon une ou plusieurs des revendications 1 à 4, **caractérisé en ce qu'**un cadre d'appui est prévu le long de la périphérie de la puce (22).

6. Module à puce selon une ou plusieurs des revendications 1 à 4, **caractérisé par** une masse de remplissage reliant les faces latérales de la puce (22) à une zone débordante (49) du support de puce (21) dépassant la surface de la puce.

7. Module à puce selon une ou plusieurs des revendications précédentes, **caractérisé en ce que** les zones de contact extérieures (26) sont garnies de matériau de brasure (42) dont le point de fusion est inférieur à la température nécessaire pour obtenir la liaison thermique entre les métallisations des surfaces de contact (33) de la puce (22) et les pistes conductrices (28) du support de puce (21).

8. Ensemble de modules présentant un agencement de supports de puce et un agencement de puces, en particulier une tranche, comportant une pluralité de modules à puce attachés les uns aux autres selon une ou plusieurs des revendications 1 à 6, dans lequel tant les supports de puce, que les puces forment respectivement un ensemble.

9. Procédé de fabrication d'un module à puce selon une ou plusieurs des revendications 1 à 7,
**caractérisé par** les étapes de procédé ci-après:
- application d'un matériau de remplissage (37) fluide sur la surface de la puce ou la face de contact de puce (35) du support de puce (21);
- pressage l'une sur l'autre d'une face de contact de puce (35) du support de puce (21) et de la surface de la puce et mise en contact des pistes conductrices (28) du support de puce (21) avec les métallisations de contact (33) associées de la puce (22), au moyen d'une application d'énergie par l'arrière, à partir de la face de la couche support qui est opposée à la face qui présente l'agencement de pistes conductrices, cette application d'énergie étant effectuée aux pistes conductrices (28) avec interposition de la couche support (23), avec refoulement simultané du matériau de remplissage (37).

10. Procédé de fabrication d'un module à puce selon une ou plusieurs des revendications 1 à 7,
**caractérisé par** les étapes de procédé consistant à:
- fournir un support de puce, muni d'une couche d'adhésif sur la face de contact de puce (35) tournée vers la puce (22) ;
- presser l'une sur l'autre de la face de contact de puce (35) du support de puce (21) et de la surface de la puce et mise en contact des pistes conductrices (28) du support de puce (21) avec les métallisations de contact (33) associées de la puce (22), par application d'énergie par l'arrière aux pistes conductrices (28) avec interposition de la couche support (23), et refoulement simultané du matériau adhésif (37).

11. Procédé de fabrication d'un module à puce selon une ou plusieurs des revendications 1 à 7,
**caractérisé par** les étapes de procédé consistant à:
- fabriquer un ensemble de modules (72) ayant un ensemble de supports de puce (74) et un ensemble de puces (73) selon la revendication 8 ;
- fabrication d'une pluralité de modules de puce (77) individuels, par individualisation d'unités formées d'au moins une puce (75) et d'un support de puce (76), mis en contact avec elle, à partir de l'ensemble de modules (73).

12. Procédé selon la revendication 11, **caractérisé par** les étapes de procédé suivantes pour la fabrication de l'ensemble de modules (72) :
- fourniture d'une tranche (73) garnie de métallisations de contact surélevées sur les faces de raccordement (86), et d'un ensemble de supports de puce (74) ayant une pluralité de structures de pistes conductrices (83), disposées sur une couche support (23) commune, avec des pistes conductrices (82) ;
- application d'un matériau de remplissage (37) fluide sur la face de contact de la tranche ou la face de contact de puce de l'ensemble de supports de puce ;
- positionnement relatif de la tranche et de l'ensemble de supports de puce, de manière à établir une position de recouvrement des métallisations de contact de la tranche et des zones de contact (89) des pistes conductrices (82) associées des structures de pistes conductrices ;
- fabrication d'une liaison en surface entre la tranche et l'ensemble de supports de puce et mise en contact des métallisations de contact de la tranche avec les pistes conductrices associées de l'ensemble de supports de puce.

13. Procédé selon la revendication 11, **caractérisé par** les étapes de procédé suivantes pour la production de l'ensemble de modules (72):
- fourniture d'une tranche (73), garnie de métallisations de contact surélevées sur les faces de raccordement (86), et d'un ensemble de supports de puce (74) ayant une pluralité de structures de pistes conductrices (83) disposées sur une couche support (23) commune, avec des pistes conductrices (82) et une couche d'adhésif (37) sur la face de contact de puce de la couche support (23) ;
- positionnement relatif de la tranche (73) et de l'ensemble de supports de puce (74), de manière à établir une position de recouvrement des métallisations de contact de la tranche et les zones de contact (89) des pistes conductrices (82) associées des structures de pistes conductrices ;
- établissement d'une liaison en surface entre la tranche (73) et l'ensemble de supports de puce (74) et mise en contact des métallisations de contact de la tranche avec les pistes conductrices associées de l'ensemble de supports de puce.

14. Procédé selon la revendication 12 ou 13, **caractérisé en ce que** l'établissement du contact des métallisations de contact avec les pistes conductrices (82) se fait à travers la couche support (23) de l'ensemble de supports de puce (74).

15. Procédé selon une ou plusieurs des revendications 12 à 14, **caractérisé en ce que**, à titre de moyens auxiliaires pour obtenir le positionnement relatif de la tranche (73) par rapport à l'ensemble de supports de puce (74), la tranche est garnie d'au moins deux tiges de positionnement (84, 85) qui s'engagent dans des ouvertures de positionnement de configuration correspondante, ménagées dans la couche support de l'ensemble de supports de puce (74).

16. Procédé selon la revendication 11, **caractérisé par** les étapes de procédé suivantes pour produire l'ensemble de modules (72) :
- fourniture d'une tranche (73) et d'un ensemble de supports de puce (74) avec une pluralité de structures de pistes conductrices (83) disposées sur une couche support (23) commune, ayant des pistes conductrices (82), la couche support (23) présentant des ouvertures dégageant la face arrière de la zone de contact de puce (89) des pistes conductrices (82) ;
- application d'un matériau de remplissage (37) fluide sur la surface de contact de la tranche (73) ou la face de contact de puce de l'ensemble de supports de puce (74), de manière que les faces de raccordement (86) de la tranche ou les ouvertures (90) de la couche support (23) restent dégagées ;
- positionnement relatif de la tranche (73) et de l'ensemble de supports de puce (74) de manière à établir une position de recouvrement des surfaces de raccordement de la tranche et les ouvertures ménagées dans la couche support de l'ensemble de supports de puce ;
- fabrication d'une liaison en surface entre la tranche (73) et l'ensemble de supports de puce (74) et mise en contact des surfaces de raccordement de la tranche avec les zones de contact de puce des pistes conductrices associées, par introduction de matériau de liaison (95) dans les ouvertures (90) de la couche support (23) de l'ensemble de supports de puce.

17. Procédé selon la revendication 11, **caractérisé par** les étapes de procédé suivantes pour la fabrication de l'ensemble de modules (72):
- fourniture d'une tranche (73) et d'un ensemble de supports de puce (74) avec une pluralité de structures de pistes conductrices (83) disposées sur une couche support (23) commune, avec des pistes conductrices (82), la couche support (23) étant garnie dune couche d'adhésif (37) sur sa face de contact de puce et présentant des ouvertures dégageant la face arrière de la zone de contact de puce (89) des pistes conductrices (82) ;
- positionnement relatif de la tranche (73) et de l'ensemble de supports de puce (74), de manière à établir une position de recouvrement des surfaces de raccordement de la tranche et des ouvertures (90) ménagées dans la couche support (23) de l'ensemble de supports de puce (74) ;
- établissement d'une liaison en surface entre la tranche (73) et l'ensemble de supports de puce (74) et mise en contact des surfaces de raccordement de la tranche avec les zones de contact de puce des pistes conductrices associées, par insertion de matériau de liaison (95) dans les ouvertures (90) de la couche support (23) de l'ensemble de supports de puce.

18. Procédé selon la revendication 16 ou 17, **caractérisé en ce que** la mise en contact s'effectue par dépôt de matériau de liaison (95) dans les ouvertures (90) de la couche support (23).

19. Procédé selon la revendication 18, **caractérisé en ce que** la mise en contact s'effectue par dépôt sans courant de matériau de liaison dans un bain de matériau.

20. Procédé selon la revendication 19, **caractérisé en ce que** l'on utilise un bain de nickel comme bain de matériau.

21. Procédé selon la revendication 16 ou 17, **caractérisé en ce que** la mise en contact s'effectue par introduction de matériau de brasure dans les ouvertures (90) de la couche support (23).

22. Procédé selon la revendication 16 ou 17, **caractérisé en ce que** la mise en contact s'effectue par introduction d'adhésif conducteur dans les ouvertures (90) de la couche support (23).

23. Procédé selon une ou plusieurs des revendications 16 à 22, **caractérisé en ce que**, simultanément à l'introduction de matériau de liaison (95) dans les ouvertures (90) de la couche support (23), une introduction de matériau de liaison s'effectue dans les évidements (91) de la couche support.

24. Procédé selon une ou plusieurs des revendications précédentes, **caractérisé en ce que** la tranche (73) est garnie d'une couche de recouvrement sur sa face arrière.

25. Procédé selon la revendication 24, **caractérisé en ce qu'**un matériau époxyde est appliqué sur la face arrière de la tranche (73) pour former la couche de couverture.

26. Procédé selon la revendication 24, **caractérisé en ce qu'**une feuille est appliquée en face arrière de la tranche (73) pour former la couche de couverture.

27. Procédé selon une ou plusieurs des revendications 11 à 26, **caractérisé en ce que** l'individualisation des modules à puce (77) à partir d'un ensemble de modules (72) s'effectue par séparation les uns des autres de modules à puce adjacents, le long de lignes de séparation (78) définies.

28. Procédé selon la revendication 27, **caractérisé en ce que** la séparation s'effectue par sciage.

29. Procédé selon une ou plusieurs des revendications 11 à 26, **caractérisé en ce que**, avant de procéder à l'individualisation, un contrôle électrique de la tranche (73) est effectué, par l'intermédiaire de la structure à pistes conductrices (83) de l'ensemble de supports de puce (74).

30. Procédé selon la revendication 16 ou 17, **caractérisé en ce que**, avant de procéder à l'individualisation des modules à puce (77) à partir de l'ensemble de modules (72), l'introduction de matériau de brasure (95) est effectuée dans les évidements (91) ménagés dans la couche support (23) de l'ensemble de supports de puce (74).

31. Procédé selon une ou plusieurs des revendications précédentes, **caractérisé en ce qu'**une pression de liaison, nécessaire pour relier le support de puce (21) ou l'ensemble de supports de puce (74) à la surface de la puce ou à la surface de la tranche, est générée en utilisant du vide.

32. Procédé selon une ou plusieurs des revendications précédentes, **caractérisé en ce que** les zones de contact extérieures (26, 91) et/ou les ouvertures (90) sont garnies d'un matériau de brasure (42, 94), en suivant un processus d'application avec gabarit, la couche support servant, pendant un procédé de refusion subséquent, à former des dépôts de matériau de brasure (29) faisant office de masque d'arrêt de brasure.

33. Procédé selon une ou plusieurs des revendications précédentes, **caractérisé en ce que** les zones de contact extérieures (26, 91) sont munies de pièces formées (57) en matériau de brasure, selon un procédé de garnissage.

34. Procédé selon une ou plusieurs des revendications précédentes, **caractérisé en ce que** la liaison entre les métallisations de contact (33) de la puce (22) ou de la tranche (73) et les pistes conductrices (28, 82) du support de puce (21) ou de l'ensemble de supports de puce (74) s'effectue selon un procédé de brasure.

35. Procédé selon une ou plusieurs des revendications 1 à 34, **caractérisé en ce que** la liaison entre les métallisations de contact (33) de la puce (22) ou de la tranche (73) et les pistes conductrices (28, 82) du support de puce (21) ou de l'ensemble de supports de puce (74) s'effectue avec un procédé de thermocompression.

36. Procédé selon une ou plusieurs des revendications 1 à 34, **caractérisé en ce que** la liaison entre les métallisations de contact (33) de la puce (22) ou de la tranche (73) et les pistes conductrices (28, 82) du support de puce (21) ou de l'ensemble de supports de puce (74) s'effectue avec un procédé aux ultrasons.
